(19) Europäisches Patentamt / European Patent Office / Office européen des brevets

(11) **EP 4 550 046 A1**

(12) **EUROPEAN PATENT APPLICATION**
published in accordance with Art. 153(4) EPC

(43) Date of publication:
**07.05.2025  Bulletin 2025/19**

(21) Application number: **23831478.5**

(22) Date of filing: **27.06.2023**

(51) International Patent Classification (IPC):
**G03F 1/24** *(2012.01)*      **G03F 1/48** *(2012.01)*
**C23C 14/06** *(2006.01)*

(52) Cooperative Patent Classification (CPC):
**C23C 14/06; G03F 1/24; G03F 1/48**

(86) International application number:
**PCT/JP2023/023882**

(87) International publication number:
**WO 2024/005038 (04.01.2024 Gazette 2024/01)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority:  **28.06.2022   JP 2022103541**

(71) Applicant: **Hoya Corporation
Tokyo 160-0023 (JP)**

(72) Inventor: **NAKAGAWA, Masanori
Tokyo 160-0023 (JP)**

(74) Representative: **Vossius & Partner
Patentanwälte Rechtsanwälte mbB
Siebertstrasse 3
81675 München (DE)**

(54) **SUBSTRATE WITH MULTILAYER REFLECTIVE FILM, REFLECTIVE MASK BLANK, REFLECTIVE MASK, AND METHOD FOR PRODUCING SEMICONDUCTOR DEVICE**

(57)     To improve adhesion between a first layer (32) and a second layer (34) in a substrate with a multilayer reflective film (90) having a protective film (3) including the first layer (32) and the second layer (34).

Provided is a substrate with a multilayer reflective film (90) including a substrate (1), a multilayer reflective film (2), and a protective film (3) including a first layer (32) and a second layer (34), in which the protective film (3) includes at least one metal element Em having a Fermi level of -4.7 eV or less and at least one additive element Ea having a Fermi level of more than -4.7 eV, and in a content distribution of a component contained in the protective film (3) with respect to a position x in a film thickness direction of the protective film (3), when a position x at which a component dominance of the second layer (34) is switched to a component dominance of the first layer (32) is an inflection point $x_1$, a content of the metal element Em is M, and a content of the additive element Ea is A, a ratio A/M at the inflection point $x_1$ is 0.020 or more.

**FIG. 1**

## Description

Technical Field

The present invention relates to a reflective mask used for manufacturing a semiconductor device and the like, a substrate with a multilayer reflective film used for manufacturing a reflective mask, and a reflective mask blank. The present invention also relates to a method for manufacturing a semiconductor device using the reflective mask.

Background Art

With the further demand for higher density and higher accuracy of VLSI devices in recent years, EUV lithography, which is an exposure technique using extreme ultraviolet (Extreme Ultra Violet, hereinafter referred to as EUV) light, has been proposed.

The reflective mask includes a multilayer reflective film for reflecting exposure light formed on a substrate, and an absorber pattern that is a patterned absorber film formed on the multilayer reflective film for absorbing exposure light. In EUV lithography using a reflective mask, an optical image reflected by a multilayer reflective film of the reflective mask is transferred onto a semiconductor substrate (transfer object) such as a silicon wafer through a reflective optical system.

Patent Literature 1 describes a reflective mask blank for manufacturing a reflective mask. Specifically, Patent Literature 1 describes a reflective mask blank including a substrate, a multilayer reflective film that is formed on the substrate and reflects exposure light, a protective film that is formed on the multilayer reflective film and protects the multilayer reflective film, and an absorber film that is formed on the protective film and absorbs exposure light. Patent Literature 1 describes that the protective film of the reflective mask blank is made of a ruthenium compound containing ruthenium (Ru) and at least one type selected from molybdenum (Mo), niobium (Nb), zirconium (Zr), yttrium (Y), boron (B), titanium (Ti), and lanthanum (La).

Citation List

Patent Literature

Patent Literature 1: JP 2005-268750 A

Summary of Invention

Technical Problem

The above described EUV lithography is an exposure technique using extreme ultraviolet light (EUV light). The EUV light is light in a wavelength band of a soft X-ray region or a vacuum ultraviolet region, specifically, light having a wavelength of about 0.2 to 100 nm. In the case of EUV lithography, EUV light having a wavelength of 13 to 14 nm (for example, a wavelength of 13.5 nm) can be used.

In the EUV lithography, a reflective mask having an absorber pattern is used. The EUV light applied to the reflective mask is absorbed in a portion with the absorber pattern, and is reflected in a portion without the absorber pattern. The multilayer reflective film is exposed at a portion where the absorber pattern does not exist. The multilayer reflective film exposed on the surface of the reflective mask reflects EUV light. In the EUV lithography, an optical image reflected by a multilayer reflective film (a portion where no absorber pattern exists) is transferred onto a semiconductor substrate (transfer object) such as a silicon wafer through a reflective optical system.

As the multilayer reflective film, a multilayer film in which elements having different refractive indexes are periodically laminated is generally used. For example, as a multilayer reflective film for EUV light having a wavelength of 13 to 14 nm (for example, a wavelength of 13.5 nm), a Mo/Si periodic laminated film in which a Mo film having a low refractive index and a Si film having a high refractive index are alternately laminated for 40 to 60 periods is used.

In order to achieve high density and high accuracy of a semiconductor device using a reflective mask, it is necessary for a reflection region (surface of a multilayer reflective film) in the reflective mask to have high reflectance to EUV light that is exposure light.

In the manufacturing step of the reflective mask, when the absorber pattern is formed, the absorber film is processed by etching via the resist pattern or the etching mask pattern. In order to process the absorber film into a designed shape, it is necessary to slightly over-etch the absorber film. At the time of over-etching, the multilayer reflective film under the absorber film is also damaged by etching. In order to prevent the multilayer reflective film from being damaged by etching, a protective film is provided between the absorber film and the multilayer reflective film. Therefore, the protective film is required to have high resistance to etching gas used for etching the absorber film.

As a material of the protective film having high resistance to the etching gas of the absorber film, for example, a metal such as Ru or RuNb is used. On the other hand, when the outermost surface of the multilayer reflective film is a low refractive index layer such as a Mo film, the low refractive index layer is easily oxidized. The reflectance of the reflective mask may decrease due to the oxidation of the low refractive index layer. In order to prevent oxidation of the low refractive index layer, a silicon-containing layer such as a Si film can be disposed on the outermost surface of the multilayer reflective film. The silicon-containing layer is a thin film for protecting the multilayer reflective film from oxidation, and thus is treated as a part of the protective film in the present description. In the present description, a thin film included in a protective film for protecting the multilayer reflective film from oxidation, such as a silicon-containing layer, is referred to as a "first layer". In addition, among the above described protective films, a thin film having high resistance to etching gas used for etching the absorber film is referred to as a "second layer". Generally, the first layer is disposed on the multilayer reflective film, and the second layer is disposed on the first layer.

In a case where the protective film of the substrate with a multilayer reflective film has a structure in which a second layer containing a metal material is disposed on a first layer (for example, a Si thin film) on the multilayer reflective film, heat treatment is performed on the substrate with a multilayer reflective film or the like in the manufacturing step of the reflective mask, which may cause a phenomenon of decreasing the reflectance of the substrate with a multilayer reflective film including the multilayer reflective film with respect to EUV light. The heat treatment on the substrate with a multilayer reflective film or the reflective mask blank may be generally performed for stress adjustment of the substrate with a multilayer reflective film or the reflective mask blank.

As described above, the case of having a structure in which the second layer is disposed on the first layer containing Si or the like may cause a phenomenon of decreasing the reflectance of the substrate with a multilayer reflective film with respect to EUV light due to heat treatment or the like in the manufacturing step of the reflective mask. The reason for this is considered to be that silicon in the first layer diffuses into the second layer. In order to prevent a decrease in the reflectance of the substrate with a multilayer reflective film, it is necessary to prevent silicon of the first layer from diffusing into the second layer. To prevent the silicon of the first layer from diffusing into the second layer, it is conceivable to nitride and/or oxidize the surface of the first layer (an interface between first layer and second layer). On the other hand, it has been found that nitriding and/or oxidizing the surface of the first layer (interface with the second layer) causes a problem of reducing adhesion between the first layer and the second layer.

Therefore, an object of the present invention is to improve adhesion between a first layer and a second layer in a substrate with a multilayer reflective film having a protective film including the first layer for protecting the multilayer reflective film from oxidation and the second layer having high resistance to etching gas used for etching an absorber film. In addition, an object of the present invention is to provide a substrate with a multilayer reflective film having a protective film including a first layer for protecting a multilayer reflective film from oxidation and a second layer having high resistance to etching gas used for etching an absorber film, the substrate with a multilayer reflective film being capable of improving adhesion between the first layer and the second layer, maintaining high reflectance to EUV light, and maintaining high etching resistance of the protective film.

In addition, an object of the present invention is to provide a reflective mask blank or a reflective mask capable of improving adhesion between a first layer and a second layer of a protective film. In addition, an object of the present invention is to provide a reflective mask blank or a reflective mask capable of improving adhesion between a first layer and a second layer, maintaining high reflectance to EUV light, and maintaining high etching resistance of a protective film.

Solution to Problem

In order to solve the above problem, the present invention has the following configurations.

(Configuration 1)

Configuration 1 is a substrate with a multilayer reflective film including a substrate, a multilayer reflective film provided on the substrate, and a protective film provided on the multilayer reflective film, wherein

the protective film includes a first layer and a second layer, and the first layer is disposed between the second layer and the multilayer reflective film,
the protective film includes at least one metal element Em and at least one additive element Ea, and a content of the metal element Em in the second layer is larger than a content of the metal element Em in the first layer,
the metal element Em is an element having a Fermi level of -4.7 eV or less,
the additive element Ea is an element having a Fermi level of more than -4.7 eV, and
in a content distribution of a component included in the protective film with respect to a position x in a film thickness direction of the protective film, when a position x at which a component dominance of the second layer is switched to a component dominance of the first layer is an inflection point $x_1$, a content of the metal element Em is M, and a content of the additive element Ea is A, a ratio A/M at the inflection point $x_1$ is 0.020 or more.

(Configuration 2)

Configuration 2 is the substrate with a multilayer reflective film according to Configuration 1, wherein the metal element Em is one or more elements selected from ruthenium (Ru), rhodium (Rh), and iridium (Ir).

(Configuration 3)

Configuration 3 is the substrate with a multilayer reflective film according to Configuration 1 or 2, wherein the additive element Ea is one or more elements selected from Tl, Hf, Ti, Zr, Y, Mn, In, Ga, Cd, Bi, Ta, Pb, Ag, Al, V, Nb, Sn, Zn, Hg, Cr, Fe, Sb, W, Mo, and Cu.

(Configuration 4)

Configuration 4 is the substrate with a multilayer reflective film according to any one of the Configurations 1 to 3, wherein the content A of the additive element Ea at the inflection point $x_1$ is 1 atom% or more and 15 atom% or less.

(Configuration 5)

Configuration 5 is the substrate with a multilayer reflective film according to any one of Configurations 1 to 4, wherein the content M of the metal element Em at the inflection point $x_1$ is 5 atom% or more and 80 atom% or less.

(Configuration 6)

Configuration 6 is the substrate with a multilayer reflective film according to any one of the Configurations 1 to 5, wherein the ratio A/M at the inflection point $x_1$ is less than 0.17.

(Configuration 7)

Configuration 7 is the substrate with a multilayer reflective film according to any one of the configurations 1 to 6, wherein the first layer includes silicon (Si) and at least one selected from nitrogen (N) and oxygen (O), and a total content of nitrogen (N) and oxygen (O) at the inflection point $x_1$ is 2 atom% or more.

(Configuration 8)

Configuration 8 is the substrate with a multilayer reflective film of Configuration 7, wherein the total content of nitrogen (N) and oxygen (O) at the inflection point $x_1$ is 35 atom% or less.

(Configuration 9)

Configuration 9 is a reflective mask blank including an absorber film on the protective film of the substrate with a multilayer reflective film of any one of Configurations 1 to 8.

(Configuration 10)

The configuration 10 is a reflective mask including an absorber pattern obtained by patterning the absorber film of the reflective mask blank of Configuration 9.

(Configuration 11)

Configuration 11 is a method for manufacturing a semiconductor device, including a step of performing a lithography process using an exposure apparatus using the reflective mask of Configuration 10 to form a transfer pattern on a transfer object.

Advantageous Effects of Invention

According to an object of the present invention, there is improved adhesion between a first layer and a second layer in a substrate with a multilayer reflective film having a protective film including the first layer for protecting the multilayer reflective film from oxidation and the second layer having high resistance to etching gas used for etching an absorber film. In addition, an object of the present invention is to provide a substrate with a multilayer reflective film having a protective film including a first layer for protecting the multilayer reflective film from oxidation and a second layer having high resistance to etching gas used for etching an absorber film, the substrate with a multilayer reflective film being capable of improving adhesion between the first layer and the second layer, maintaining high reflectance to EUV light, and maintaining high etching resistance of the protective film.

In addition, the present invention can provide a reflective mask blank or a reflective mask capable of improving adhesion between a first layer and a second layer of a protective film. In addition, the present invention can provide a reflective mask blank or a reflective mask capable of improving adhesion between a first layer and a second layer, maintaining high reflectance to EUV light, and maintaining high etching resistance of a protective film.

Brief Description of Drawings

Fig. 1 is a schematic cross-sectional view showing an example of a substrate with a multilayer reflective film of the present embodiment.
Fig. 2 is a schematic cross-sectional view showing an example of a reflective mask blank of the present embodiment.
Fig. 3 is a schematic cross-sectional view showing another example of a reflective mask blank of the present embodiment.
Fig. 4 is a schematic cross-sectional view showing an example of a method for manufacturing the reflective mask of the present embodiment.
Fig. 5 is a schematic view showing an example of an EUV exposure apparatus.
Fig. 6 is a view for explaining the relationship between the total content (atom%) (X axis) of nitrogen (N) and oxygen (O) at the inflection point $x_1$ and the ratio A/M (Y axis) of the content M of the metal element Em and the content A of the additive element Ea in the second aspect of the protective film of the substrate with a multilayer reflective film of the present embodiment.
Fig. 7 is a view for explaining a relationship between a distribution ratio $y(x_1)$ (X axis) at an inflection point $x_1$ and a gradient $y'(x_1)$ (Y axis) of the distribution ratio $y(x_1)$ at the inflection point $x_1$ in the

third aspect of the protective film 3 of the present embodiment.

Description of Embodiments

Hereinafter, embodiments of the present invention will be specifically described with reference to the drawings. The following embodiments are aspects for specifically describing the present invention, and do not limit the present invention within the scope thereof.

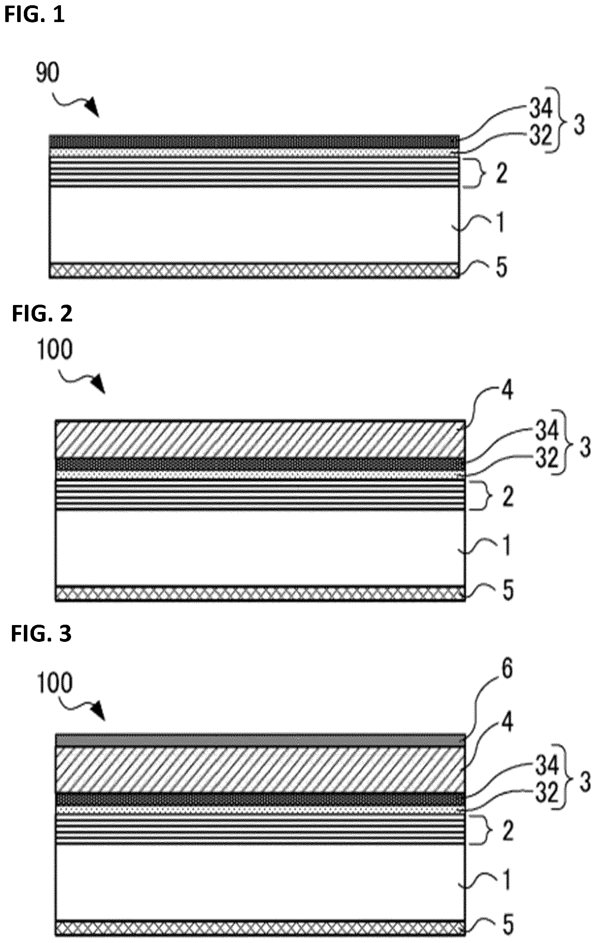

Fig. 1 is a schematic cross-sectional view showing an example of a substrate with a multilayer reflective film 90 of the present embodiment. A substrate with a multilayer reflective film 90 illustrated in Fig. 1 includes a multilayer reflective film 2 and a protective film 3 on a substrate 1. The protective film 3 includes a first layer 32 and a second layer 34 in this order on the multilayer reflective film 2. The substrate with a multilayer reflective film 90 can further include another thin film such as a back conductive film 5.

Fig. 2 is a schematic cross-sectional view showing an example of a reflective mask blank 100 of the present embodiment. The reflective mask blank 100 illustrated in Fig. 2 includes a multilayer reflective film 2, a protective film 3, and an absorber film 4 on a substrate 1. The reflective mask blank 100 may have a back conductive film 5. The substrate with a multilayer reflective film 90 can further include another thin film such as a resist film 11.

Fig. 3 is a schematic cross-sectional view illustrating another example of the reflective mask blank 100. The reflective mask blank 100 illustrated in Fig. 3 further includes an etching mask film 6 on the absorber film 4 in addition to the configuration illustrated in Fig. 2. The reflective mask blank 100 can further include another thin film such as the resist film 11.

In the present description, "disposing (forming) the thin film B on the thin film A (or the substrate)" includes not only a case where the thin film B is disposed (formed) in contact with the surface of the thin film A (or the substrate) but also a case of having another thin film C between the thin film A (or the substrate) and the thin film B. Further, in the present description, for example, "the thin film B is disposed in contact with the surface of the thin film A (or the substrate)" means that the thin film A (or the substrate) and the thin film B are disposed so as to be in direct contact with each other without interposing another thin film between the thin film A (or the substrate) and the thin film B. Further, in the present description, "on" does not necessarily mean the upper side in the vertical direction. "On" merely indicates a relative positional relationship of a thin film, a substrate, and the like.

<Substrate with a multilayer reflective film 90>

The present embodiment is the substrate with a multilayer reflective film 90 including the substrate 1, the multilayer reflective film 2 provided on the substrate 1, and the protective film 3 provided on the multilayer reflective film 2. The substrate with a multilayer reflective film 90 of the present embodiment will be specifically described.

<<Substrate 1>>

The substrate 1 preferably has a low thermal expansion coefficient within a range of $0 \pm 5$ ppb/°C in order to prevent distortion of the transfer pattern due to heat during exposure with EUV light. As a material having a low thermal expansion coefficient in this range, for example, $SiO_2$-$TiO_2$-based glass, multicomponent glass ceramics, or the like can be used.

A main surface (first main surface) of the substrate 1 on which a transfer pattern (absorber pattern 4a described later) is formed is preferably processed in order to increase flatness. Increasing the flatness of the main surface of the substrate 1 can enhance the positional accuracy and transfer accuracy of the pattern. For example, in the case of EUV exposure, the flatness is preferably 0.1 $\mu$m or less, more preferably 0.05 $\mu$m or less, and particularly preferably 0.03 $\mu$m or less in a region of 132 mm $\times$ 132 mm on the main surface on the side where the transfer pattern of the substrate 1 is formed. A second main surface (back surface) opposite to the side on which the transfer pattern is formed is a surface fixed to the exposure apparatus by an electrostatic chuck. In a region of 142 mm $\times$ 142 mm on the back surface, flatness is 0.1 $\mu$m or less, more preferably 0.05 $\mu$m or less, and particularly preferably 0.03 $\mu$m or less. In the present description, the flatness is a value representing warpage (deformation amount) of the surface indicated by total indicated reading (TIR). The flatness (TIR) is an absolute value of a height difference between the highest position of the surface of the substrate 1 above the focal plane and the lowest position of the surface of the substrate 1 below the focal plane, with the plane determined by the least squares method with reference to the surface of the substrate 1 as the focal plane.

In the case of EUV exposure, the surface roughness of the main surface of the substrate 1 on the side where the transfer pattern is formed is preferably 0.1 nm or less in root mean square roughness (Rq). The surface roughness can be measured with an atomic force microscope.

The substrate 1 preferably has high rigidity in order to prevent deformation of a thin film (such as the multilayer reflective film 2) formed thereon due to film stress. In particular, those having a high Young's modulus of 65 GPa or more are preferable.

<<Multilayer reflective film 2>>

The substrate with a multilayer reflective film 90 according to the embodiment includes the multilayer reflective film 2. The multilayer reflective film 2 imparts a function of reflecting EUV light in the reflective mask 200. The multilayer reflective film 2 is a multilayer film in which layers containing elements having different refractive indexes as main components are periodically laminated.

In general, as the multilayer reflective film 2, a multilayer film in which a thin film (high refractive index layer) of a light element that is a high refractive index material or a compound thereof and a thin film (low refractive index layer) of a heavy element that is a low refractive index material or a compound thereof are alternately laminated for about 40 to 60 periods is used.

The multilayer film used as the multilayer reflective film 2 can have a structure of a plurality of periods of a laminated structure of a high refractive index layer/a low refractive index layer in which a high refractive index layer and a low refractive index layer are laminated in this order from the substrate 1 side as one period. In addition, the multilayer film can have a structure in which a plurality of periods of a laminated structure of a low refractive index layer/a high refractive index layer in which a low refractive index layer and a high refractive index layer are laminated in this order from the substrate 1 side are laminated as one period. The outermost layer of the multilayer reflective film 2, that is, the surface layer of the multilayer reflective film 2 on the side opposite to the substrate 1 side is preferably a high refractive index layer. In the multilayer film described above, in a case of a plurality of period of lamination in which a high refractive index layer/a low refractive index layer are laminated in this order from the substrate 1 side as one period, the uppermost layer is the low refractive index layer. In this case, if the low refractive index layer constitutes the outermost surface of the multilayer reflective film 2, easy oxidation occurs, and thus the reflectance of the reflective mask 200 decreases. Therefore, it is preferable to further form a high refractive index layer on the uppermost low refractive index layer to form the multilayer reflective film 2. The high refractive index layer formed on the uppermost low refractive index layer can be the first layer 32 of the protective film 3 described later. On the other hand, in the above described multilayer film, in a case of a plurality of period of lamination of a low refractive index layer/a high refractive index layer in which a low refractive index layer and a high refractive index layer are laminated in this order from the substrate 1 side as one period, the uppermost layer is the high refractive index layer. Therefore, in this case, it is not necessary to form a further high refractive index layer. The uppermost high refractive index layer in this case can also serve as a first layer 32 of the protective film 3 described later.

As the high refractive index layer, a layer containing silicon (Si) can be used. As the material containing Si, in addition to elemental Si, a Si compound containing boron (B), carbon (C), nitrogen (N), oxygen (O) and/or hydrogen (H) can be used. Using the high refractive index layer containing Si can provide the reflective mask 200 having excellent reflectance of EUV light. In addition, as the low refractive index layer, a simple metal selected from molybdenum (Mo), ruthenium (Ru), rhodium (Rh), and platinum (Pt), or an alloy thereof can be used. Boron (B), carbon (C), nitrogen (N), oxygen (O), and/or hydrogen (H) may be added to these simple metals or alloys. In the substrate with a multilayer reflective film 90 of the present embodiment, the low refractive index layer is preferably a molybdenum (Mo) layer, and the high refractive index layer is preferably a silicon (Si) layer. For example, as the multilayer reflective film 2 for reflecting EUV light having a wavelength of 13 nm to 14 nm (for example, a wavelength of 13.5 nm), a Mo/Si periodic laminated film in which a Mo layer and a Si layer are alternately laminated for about 40 to 60 periods can be preferably used. In the substrate with a multilayer reflective film 90 of the present embodiment, the low refractive index layer is preferably a ruthenium (Ru) layer, and the high refractive index layer is preferably a silicon (Si) layer. For example, as the multilayer reflective film 2 for reflecting EUV light having a wavelength of 13 nm to 14 nm (for example, a wavelength of 13.5 nm), a Ru/Si periodic laminated film in which a Ru layer and a Si layer are alternately laminated for about 30 to 40 periods can be preferably used.

The reflectance of the multilayer reflective film 2 singly is typically 65% or more, and the upper limit is typically 73%. The film thickness and period of each constituent layer of the multilayer reflective film 2 can be appropriately selected according to the exposure wavelength. Specifically, the film thickness and period of each constituent layer of the multilayer reflective film 2 can be selected so as to satisfy the Bragg reflection law. In the multilayer reflective film 2, there are a plurality of high refractive index layers and a plurality of low refractive index layers, but the film thicknesses of the high refractive index layers or the film thicknesses of the low refractive index layers are not necessarily the same each other.

A method for forming the multilayer reflective film 2 is known in the art. The multilayer reflective film 2 can be formed by forming each layer by, for example, an ion beam sputtering method. In the case of the Mo/Si periodic multilayer film described above, for example, by the ion beam sputtering method, a Si film having a thickness of about 4 nm is first formed on the substrate 1 using a Si target, then a Mo film having a thickness of about 3 nm is formed using a Mo target, and as this is one period, the lamination is performed for 40 to 60 periods to form the multilayer reflective film 2 (the outermost layer is a Si film). In a case of 60 cycles, the number of steps is increased from 40 periods, but the reflectance for EUV light can be increased.

<<Protective film 3>>

As illustrated in Fig. 1, the substrate with a multilayer reflective film 90 of the present embodiment has a predetermined protective film 3 on the multilayer reflective film 2. When the reflective mask 200 is manufactured, an absorber film 4 is etched to be processed into an absorber pattern 4a. The protective film 3 has high etching resistance, and thus damage to the surface of the multilayer reflective film 2 can be suppressed when the absorber film 4 is etched. Therefore, having the predetermined protective film 3 on the multilayer reflective film 2 can suppress damage to the surface of the multilayer reflective film 2 when the reflective mask 200 is manufactured using the substrate with a multilayer reflective film 90. Therefore, the reflectance characteristic of the obtained reflective mask 200 with respect to the EUV light becomes favorable.

In the present description, the predetermined protective film 3 that can be used for the substrate with a multilayer reflective film 90 of the present embodiment may be referred to as a "protective film 3 of the present embodiment".

The protective film 3 of the present embodiment includes a first layer 32 and a second layer 34. The first layer 32 is disposed between the second layer 34 and the multilayer reflective film 2. The first layer 32 is a thin film having a function of protecting the multilayer reflective film 2 from oxidation. In the present description, the first layer 32 is a part of the protective film 3. The first layer 32 can also serve as the uppermost layer of the multilayer reflective film 2. The second layer 34 is a thin film having a function of having high resistance to an etching gas used for etching the absorber film 4. The second layer 34 needs to be a thin film having high reflectance to EUV light and high etching resistance to etching gas.

In a case where the protective film 3 has a structure in which the second layer 34 is disposed on the first layer 32, there may occur a phenomenon that the reflectance of the substrate with a multilayer reflective film 90 with respect to EUV light decreases due to heat treatment or the like in the reflective mask manufacturing step. The reason for this is considered to be that a predetermined element of the first layer 32 (an element exhibiting the function of the first layer 32) diffuses into the second layer 34. In order to prevent a decrease in the reflectance of the substrate with a multilayer reflective film 90, it is necessary to prevent a predetermined element of the first layer 32 from diffusing into the second layer 34. To prevent a predetermined element of the first layer 32 from diffusing into the second layer 34, it is considered to nitride and/or oxidize the surface of the first layer 32 (interface between first layer 32 and second layer 34). On the other hand, it has been found that nitriding and/or oxidizing the surface of the first layer 32 (interface with the second layer 34) causes a problem of reducing adhesion between the first layer 32 and the second layer 34. When the adhesion between the first layer 32 and the second layer 34 is reduced, a film peeling defect may occur.

The protective film 3 of the present embodiment contains at least one metal element Em and at least one additive element Ea. That is, the first layer 32 and the second layer 34 constituting the protective film 3 can contain the metal element Em and/or the additive element Ea. The protective film 3 of the present embodiment contains the metal element Em, thereby allowing the absorber film 4 to have high etching resistance to the etching gas. In addition, the protective film 3 of the present embodiment contains the additive element Ea, thereby allowing adhesion between the first layer 32 and the second layer 34 to be improved. Therefore, the occurrence of film peeling defects can be suppressed by the protective film 3 of the present embodiment. That is, with the protective film 3 of the present embodiment, it is possible to obtain the substrate with a multilayer reflective film 90 capable of improving adhesion between the first layer 32 and the second layer 34 while maintaining high etching resistance of the protective film 3.

<<<Metal element Em>>>

The protective film 3 contains at least one metal element Em. The metal element Em is an element having a Fermi level of -4.7 eV or less. In the present description, the content (atom%) of the metal element Em is indicated by a symbol "M". In addition, in the present description, the metal element Em is referred to as an Em element.

The metal element Em is an element (metal element) for exhibiting a function as the protective film 3. The metal element Em is an element having a Fermi level of -4.7 eV or less, and thus has low reactivity with a chlorine (Cl)-based gas, a bromine (Br)-based gas, a fluorine (F)-based gas, and a gas containing nitrogen and/or oxygen as constituent elements used in a reactive sputtering method. Therefore, when the metal element Em is used as the material of the protective film 3, the material is less likely to deteriorate, and the function as the protective film 3 is less likely to deteriorate. Therefore, when the metal element Em is selected according to the material of the absorber film 4 disposed on the protective film 3 and the metal element Em is used as the material of the protective film 3, the protective film 3 having high etching resistance can be obtained.

In the present description, the Fermi level of a certain element refers to an energy value of the Fermi level of a pure substance of a simple element when the vacuum level is taken as an origin (zero). In the present description, the Fermi level of the metal material can be energy having a negative work function value. For example, when the metal element Em is Ru, the work function of the pure substance of the simple element of Ru (pure substance of Ru metal) is 4.7 eV, and thus the Fermi level of Ru is - 4.7 eV in the present description. The same applies to an additive element Ea described later.

The metal element Em can be an element having a Fermi level equal to or less than the Fermi level of Ru. It is known that Ru can be preferably used as an element constituting the protective film 3. Therefore, using an element (metal element) having a Fermi level (Fermi level having a large negative value) equal to or less than the Fermi level of Ru can provide a thin film having high etching resistance.

Examples of the element having a Fermi level equal to or less than the Fermi level of Ru include Ru, Tc, Os, Co, Re, Rh, Pd, Au, Ni, Ir, and Pt. As the metal element Em, at least one selected from these elements can be used.

The metal element Em contained in the protective film 3 of the present embodiment is preferably one or more elements selected from ruthenium (Ru), rhodium (Rh), and iridium (Ir). The metal element Em contained in the protective film 3 of the present embodiment can be only one or more elements selected from ruthenium (Ru), rhodium (Rh), and iridium (Ir). Using these elements can more reliably provide the protective film 3 having high etching resistance while maintaining high reflectance.

Specifically, when the protective film 3 contains Rh or Ir as the metal element Em, the etching resistance of the protective film 3 can be improved. In addition, when the protective film 3 contains Ru as the metal element Em, the optical characteristics of the protective film 3 can be appropriately adjusted.

<<< Additive element Ea>>>

The protective film 3 contains at least one additive element Ea. The additive element Ea is an element having a Fermi level of more than -4.7 eV. In the present description, the content (atom%) of the additive element Ea is represented as a symbol "A". In addition, in the present description, the additive element Ea is referred to as an Ea element.

The protective film 3 contains the additive element Ea, thereby allowing adhesion between the first layer 32 and the second layer 34 constituting the protective film 3 to be improved. The additive element Ea is an element having a Fermi level of more than -4.7 eV, and thus has high reactivity with other elements. Therefore, the protective film 3 containing the additive element Ea can contribute to improvement of adhesion between the first layer 32 and the second layer 34.

The additive element Ea can be an element having a Fermi level equal to or more than the Fermi level of Cu. Cu can be used as an element capable of improving adhesion between two types of thin films. Therefore, using an element having a Fermi level (Fermi level with a small negative value) equal to or more than the Fermi level of Cu can contribute to improvement of adhesion between the first layer 32 and the second layer 34.

The additive element Ea contained in the protective film 3 of the present embodiment is preferably one or more elements selected from Tl, Hf, Ti, Zr, Y, Mn, In, Ga, Cd, Bi, Ta, Pb, Ag, Al, V, Nb, Sn, Zn, Hg, Cr, Fe, Sb, W, Mo, and Cu. The additive element Ea contained in the protective film 3 of the present embodiment is preferably one or more elements selected from Tl, Hf, Ti, Zr, Y, Mn, In, Ga, Cd, Bi, Ta, Pb, Ag, Al, V, Nb, Sn, Zn, Hg, Cr, Fe, Sb, W, Mo, and Cu. Using these elements can more reliably contribute to improving the adhesion between the first layer 32 and the second layer 34.

More preferably, the additive element Ea contained in the protective film 3 of the present embodiment is at least one selected from Ti, Zr, Ta, Nb, and Cr. In addition, it is more preferable that the additive element Ea contained in the protective film 3 of the present embodiment is at least one selected from the group consisting of Ta, Nb, and Cr. Using these elements can not only improve the adhesion between the first layer 32 and the second layer 34 but also improve the cleaning resistance.

If nitrogen is contained in the vicinity of the surface of the first layer 32 (the interface between the first layer 32 and the second layer 34), it is more preferable to use Cr as the additive element Ea contained in the protective film 3 of the present embodiment. This is because Cr, due to nitriding thereof, can contribute to reducing the extinction coefficient, reducing the absorption of EUV light, and improving the reflectance. On the other hand, Hf, Ti, Zr, Y, V, and Nb, due to nitriding thereof, tend to increase the extinction coefficient, enhance the absorption of EUV light, and reduce the reflectance.

If oxygen is contained in the vicinity of the surface of the first layer 32 (the interface between the first layer 32 and the second layer 34), it is preferable to use at least one selected from Hf, V, and Cr as the additive element Ea contained in the protective film 3 of the present embodiment. This is because Hf, V, and Cr, due to oxidation thereof, can contribute to reducing the extinction coefficient, reducing the absorption of EUV light, and improving the reflectance. On the other hand, Ti, Zr, Y, and Nb, due to nitriding thereof, tend to increase the extinction coefficient, enhance the absorption of EUV light, and reduce the reflectance.

The metal element Em can be contained in either the first layer 32 or the second layer 34. That is, if the metal element Em can be present at the interface between the first layer 32 and the second layer 34, the metal element Em can be added during the formation of the first layer 32, or the metal element Em can be added during the second layer 34. In addition, the metal element Em can be added during formation of both the first layer 32 and the second layer 34.

<<<First Layer 32>>>

The first layer 32 of the protective film 3 of the present embodiment can be disposed on and in contact with the multilayer reflective film 2. The first layer 32 is a thin film that is a part of the protective film 3 for protecting the multilayer reflective film 2 from oxidation.

The material of the first layer 32 is not particularly limited as long as it is a material that can protect the multilayer reflective film 2 from oxidation. Examples of materials for the first layer 32 include materials containing silicon (Si) (for example, Si, SiN, SiO, SiON, and SiC) and materials containing boron (B) and carbon (C) (for example, $B_4C$). The first layer 32 can be, for example, a thin film formed under conditions such that it is made only of silicon (Si), a thin film formed under conditions such that it is made only of SiN, or a thin film formed under conditions such that it is made only of $B_4C$. If the uppermost layer of the multilayer reflective film 2 is a high refractive index layer, the uppermost high refractive index layer can also serve as the first layer 32 of the protective film 3.

In the first layer 32 in the present description, "a thin film formed under conditions such that it is made only of silicon (Si)", "a thin film formed under conditions such that it is made only of SiN", or "a thin film formed under conditions such that it is made only of $B_4C$" means a thin film formed under conditions for forming a thin film made only of silicon (Si), a thin film formed under conditions such that it is made only of SiN, or a thin film formed under conditions for forming a thin film made only of $B_4C$, during the formation of the first layer 32. After the first layer 32 (and the second layer 34 described below) are formed, elements other than those constituting the first layer 32 may diffuse into the first layer 32 from the nearby multilayer reflective film 2 and second layer 34. In this case, for example, the first layer 32, which is a "thin film formed under conditions such that it is made only of silicon (Si)", contains elements other than silicon (Si) that diffuse from other layers after the first layer 32 is formed. As described above, elements of other thin films diffuse into the first layer 32 from thin films adjacent to the first layer 32, whereby a thin film formed under conditions such that it is made only of a specified element generally contains elements other than the specified element. Therefore, a thin film formed under conditions such that it is made only of silicon (Si) can be a thin film containing Si. In addition, a thin film formed under conditions such that it is made only of SiN can be a thin film containing SiN. In addition, a thin film formed under conditions such that it is made only of $B_4C$ can be a thin film containing $B_4C$.

The first layer 32 of the protective film 3 of the present embodiment can be formed by various known methods, such as the ion beam sputtering method, the sputtering method, the reactive sputtering method, the chemical vapor deposition (CVD) method, and the vacuum deposition method.

If the first layer 32 is a thin film formed under conditions such that it is made only of silicon (Si), the first layer 32 can be formed under conditions such that it is made only of silicon (Si). For example, the first layer 32 can be formed by the ion

EP 4 550 046 A1

beam sputtering method using a Si target.

If the first layer 32 is a thin film formed under conditions such that it is made only of SiN, for example, the first layer 32 can be formed by the DC magnetron sputtering method (reactive sputtering method) using a Si target in a nitrogen gas atmosphere.

If the first layer 32 is a thin film formed under conditions such that it is made only of $B_4C$, for example, the first layer 32 can be formed by the ion beam sputtering method using a target containing B and C in a predetermined composition.

The first layer 32 can be a thin film formed under conditions such that it contains the additive element Ea. The first layer 32 can be a thin film containing Si, SiC and/or $B_4C$ and the additive element Ea. The first layer 32 can include the additive element Ea. Containing the additive element Ea in the first layer 32 allows the additive element Ea to be present at the interface between the first layer 32 and the second layer 34. As a result, the adhesion between the first layer 32 and the second layer 34 can be improved.

The first layer 32 can further contain at least one selected from nitrogen (N) and oxygen (O) in a thin film containing Si, SiC and/or $B_4C$ and the additive element Ea. The first layer 32 preferably contains nitrogen (N) and/or oxygen (O) in the vicinity of the interface with the second layer 34. If the first layer 32 has a high content of nitrogen (N) and/or oxygen (O), the diffusion of elements (for example, silicon (Si)) from the first layer 32 into the second layer 34 can be suppressed. As a result, reduction in the reflectance of the second layer 34 due to diffusion of elements in the first layer 32 can be suppressed.

In order to introduce nitrogen (N) and/or oxygen (O) into the first layer 32 or the second layer 34, the first layer 32 or the second layer 34 can be formed in a nitrogen gas and/or oxygen gas atmosphere by the DC magnetron sputtering method (reactive sputtering method). As a result, reduction in the reflectance of the second layer 34 due to diffusion of elements in the first layer 32 can be suppressed.

As described above, in order to prevent the elements of the first layer 32 from diffusing into the second layer 34, it is preferable to introduce nitrogen (N) and/or oxygen (O) to the interface between the first layer 32 and the second layer 34 to increase the concentration of nitrogen (N) and/or oxygen (O) at the interface between the first layer 32 and the second layer 34. However, if the concentration of nitrogen (N) and/or the concentration of oxygen (O) at the interface between the first layer 32 and the second layer 34 becomes too high, the reflectance decreases and the adhesion deteriorates, and thus it is necessary to maintain a predetermined concentration. This point will be described later.

<<<Second Layer 34>>>

The second layer 34 of the protective film 3 of the present embodiment is disposed on the first layer 32 and in contact with the first layer 32. The second layer 34 can be a thin film that has the function of the protective film 3, that is, increasing the resistance of the protective film 3 to etching gas and the resistance to cleaning.

The second layer 34 contains the above-described metal element Em. The second layer 34 can be a thin film formed under conditions such that it contains the metal element Em. The content of the metal element Em in the second layer 34 is larger than the content of the metal element Em in the first layer 32. This is because the second layer 34 needs to be a thin film having high etching resistance.

The metal element Em contained in the second layer 34 is preferably one or more elements selected from ruthenium (Ru), rhodium (Rh), and iridium (Ir). Using these elements can provide the second layer 34 having high etching resistance while maintaining a high reflectance.

The second layer 34 can be a thin film formed under conditions such that it contains the additive element Ea. The second layer 34 can contain the additive element Ea. Containing the additive element Ea in the second layer 34 allows the additive element Ea to be present at the interface between the first layer 32 and the second layer 34. As a result, the adhesion between the first layer 32 and the second layer 34 can be improved.

The second layer 34 can be a thin film formed under conditions such that it contains the metal element Em and the additive element Ea. The second layer 34 can contain both the metal element Em and the additive element Ea. Containing the metal element Em in the second layer 34 can provide the second layer 34 having high etching resistance. In addition, the second layer 34 contains the additive element Ea, thereby allowing the adhesion between the first layer 32 and the second layer 34 to be improved more reliably.

In the second layer 34 in the present description, "a thin film formed under conditions such that it contains the metal element Em" or "a thin film formed under conditions such that it contains the additive element Ea" means a thin film formed under conditions for forming a thin film containing the metal element Em, or a thin film formed under conditions for forming a thin film containing the additive element Ea, during the formation of the first layer 32. After the second layer 34 is formed, elements other than those constituting the second layer 34 may diffuse from the first layer 32 into the second layer 34. In this case, for example, a "thin film formed under conditions such that it contains the metal element Em" contains an element (for example, silicon (Si)) that diffuses from the first layer 32 to the second layer 34 after the first layer 32 is formed. As described above, elements of other thin films diffuse into the second layer 34 from a thin film in the vicinity of the second layer 34, whereby a thin film formed under conditions such that it contains a specific element generally contains elements other than the specific element.

The content of the metal element Em in the second layer 34 is preferably 40 to 95 atom%, and more preferably 50 to 90 atom%. The content of the additive element Ea in the second layer 34 is preferably 1 to 10 atom%, and more preferably 2 to 8 atom%. The content herein indicates the content (atom%) at the starting point (x = 0) of the curve fitting described below. The above-described content is the content at the position where the total content (atom%) of the Em element and the Ea element is at a maximum value, and thus can also be said to be the composition at the center of the second layer 34.

The second layer 34 can further contain at least one selected from nitrogen (N) and oxygen (O). The second layer 34 can be a thin film formed under conditions such that it contains a metal element Em, an additive element Ea, and at least one selected from nitrogen (N) and oxygen (O). The second layer 34 can be a thin film formed under conditions such that it only contains the metal element Em, the additive element Ea, and at least one selected from nitrogen (N), and oxygen (O).

In order for the second layer 34 to have a high reflectance for EUV light, the content of nitrogen (N) and/or oxygen (O) of the second layer 34 is preferably low. On the other hand, if the content of nitrogen (N) and/or oxygen (O) is high, the diffusion of elements (for example, silicon (Si)) of the first layer 32 into the second layer 34 can be suppressed. Suppressing the diffusion of elements (for example, silicon (Si)) of the first layer 32 into the second layer 34 allows suppress the effective film thickness of the second layer 34, which functions as the protective film 3, to become thin. In consideration of the above, the second layer 34 preferably contains nitrogen (N) and/or oxygen (O) in the vicinity of the interface with the first layer 32. This makes it possible to suppress reduction in the reflectance of the multilayer reflective film 2 for EUV light, which is caused by the elements of the first layer 32 diffusing into the second layer 34.

The second layer 34 of the protective film 3 of the present embodiment can be formed by various known methods, such as the ion beam sputtering method, the sputtering method, the reactive sputtering method, the chemical vapor deposition (CVD) method, and the vacuum deposition method. The second layer 34 of the protective film 3 of the present embodiment is preferably formed by the magnetron sputtering method (reactive sputtering method) in a nitrogen gas atmosphere. As the target, for example, a single metal target or an alloy target of the metal components (metal elements, for example, the metal element Em and/or the additive element Ea) contained in the second layer 34 can be used. If the second layer 34 is formed by the reactive sputtering method, the second layer 34 can be formed continuously in a nitrogen gas atmosphere after the first layer 32 is formed.

If the second layer 34 is a thin film formed under conditions such that it contains the metal element Em, the additive element Ea, and nitrogen (N) and/or oxygen (O), the second layer 34 can be formed, for example, by the DC magnetron sputtering method (reactive sputtering method) in a nitrogen (N) gas and/or oxygen (O) gas atmosphere using an alloy target of at least one metal element Em and at least one additive element Ea.

When forming the second layer 34, the film formation conditions such as the flow rate (pressure) of the nitrogen gas and/or the applied power are changed to allow formation of the second layer 34 having a predetermined composition distribution. However, when appropriate film formation conditions are selected, the second layer 34 having a predetermined composition distribution can be formed due to diffusion of elements in the second layer 34, even if the film formation conditions are maintained to be constant. For example, in a case of obtaining the second layer 34 containing silicon (Si), even if the second layer 34 is formed under conditions such that it contains no silicon (Si), the second layer 34 containing silicon (Si) can be obtained after the film formation due to diffusion of silicon (Si) from the first layer 32.

The second layer 34 is preferably formed continuously after the formation of the first layer 32, without taking the layer out of the film formation apparatus into the atmosphere. If the first layer 32 is formed and then is taken out from the film formation apparatus into the atmosphere, the surface of the first layer 32 may be excessively oxidized or contaminated with unexpected elements. In addition, the surface of the first layer 32 is covered with a nitride film rather than an oxide film, tending to result in better adhesion between the first layer 32 and the second layer 34 and a higher reflectance. Therefore, it is preferable that the surface of the first layer 32 is not covered with an oxide film but with a nitride film. Therefore, in order to appropriately control the oxygen concentration at the interface between the first layer 32 and the second layer 34, it is preferable to form the first layer 32 and the second layer 34 continuously without taking out the layers from the film formation apparatus into the atmosphere.

<<<Content distribution of components in first layer 32 and second layer 34>>>

The protective film 3 of the present embodiment includes a first layer 32 and a second layer 34. The first layer 32 is formed on the multilayer reflective film 2 and the second layer 34 is formed on the first layer 32. The second layer 34 can be formed so as to be in contact with the first layer 32.

As described above, elements contained in the first layer 32 typically diffuse into the second layer 34. In addition, the elements contained in the second layer 34 typically diffuse into the first layer 32. Thus, the elements contained in the first layer 32 and the second layer 34 typically diffuse mutually. As a result of investigating the state of mutual diffusion of elements contained in the first layer 32 and the second layer 34, the inventors have found that in the region where the elements (components) of the first layer 32 and the second layer 34 mutually diffuse, a predetermined content distribution of a component contained in the protective film 3 with respect to a position x in the film thickness direction is related to the adhesion between the first layer 32 and the second layer 34, and reached the present invention.

Specifically, the predetermined content distribution of the components in the protective film 3 of this embodiment is a distribution in which when the thickness direction (depth direction) of the protective film 3 is the x-axis and the position in the thickness direction (depth direction) of the protective film 3 is the position x, the position x at which the component dominance of the second layer 34 switches to the component dominance of the first layer 32 is the inflection point $x_1$, the content of the metal element Em is M, and the content of the additive element Ea is A, the ratio A/M at the inflection point $x_1$ is 0.020 or more. In the present description, the x-axis, which is the thickness direction (depth direction) of the protective film 3, can be regarded as the direction in which the value of x increases from the surface of the protective film 3 that forms the absorber film toward the interface between the protective film 3 and the multilayer reflective film.

The predetermined content distribution of the components contained in the protective film 3 will be described below.

The content distribution of components contained in the protective film 3 (the first layer 32 and the second layer 34) with respect to the position x in the thickness direction of the protective film 3 of the present embodiment can be measured by, for example, energy dispersive X-ray spectroscopy (EDX) using a scanning transmission electron microscope (STEM). The content distribution can also be measured using other analytical methods, such as X-ray photoelectron spectroscopy (XPS). The components (elements) contained in the first layer 32 and the second layer 34 are identified, and the content of each component is measured with respect to the position x in the thickness direction of the protective film 3, thereby allowing to provide the content distribution of each component. In the measurement by the EDX method or the XPS method, the composition of each layer may be identified by measuring the state of a reflective mask blank having the absorber film 4, or the absorber film 4 and the etching mask film 6 on the protective film 3, or the state of the reflective mask after patterning the absorber film 4.

Then, based on the measured values of the content of each component for the position x in the thickness direction of the protective film 3, the following y(x) for the position x is determined. In the present description, y(x) may be simply referred to as the "distribution ratio".

y(x) = (the total content of components in the first layer 32 at the position x)/(the total content of components in the first layer 32 and the second layer 34 at the position x)

For example, if the first layer 32 is a thin film formed under conditions such that it contains silicon (Si), nitrogen (N) and oxygen (O), and the second layer 34 is a thin film formed under conditions such that it contains Ru (metal element Em), Rh (metal element Em), Cr (additive element Ea), nitrogen (N), and oxygen (O), the distribution ratio y(x) is as follows. Nitrogen (N) and oxygen (O) are present in both the first layer 32 and the second layer 34, but they do not need to be counted twice in the denominator of the formula below.

y(x) = (the total content of the Si content, the N content, and the O content at the position x)/(the total content of the Si content, the N content, the O content, the Ru content, the Rh content, and the Cr content at the position x)

In the above example of the distribution ratio y(x), the first layer 32 is a thin film formed under conditions such that it contains Si, and is not a thin film formed under conditions such that it contains Ru, Rh, and Cr. Therefore, Si is selected as the component of the first layer 32, and Ru, Rh and Cr are not selected. Similarly, the second layer 34 is a thin film formed under conditions such that it contains Ru, Rh, and Cr, and is not a thin film formed under conditions such that it contains Si. Therefore, Ru, Rh, and Cr are selected as the components of the second layer 34, and Si is not selected. In addition, nitrogen (N) and oxygen (O), which are gases at room temperature, may be contained in the first layer 32 and the second layer 34. Therefore, even if the first layer 32 is a thin film formed under conditions such that it contains only silicon (Si), the first layer 32 can contain nitrogen (N) and/or oxygen (O) as components. In addition, the distribution ratio y(x) can be determined in consideration of the content distribution of the measurement results, in addition to the film formation conditions.

In particular, in a case of quantifying elements using energy dispersive X-ray spectroscopy (EDX) with a scanning transmission electron microscope (STEM), the analytical sample needs to be processed into a rectangular shape using a focused ion beam (FIB) or the like. In this case, a conductive protective film such as carbon (C) and/or platinum (Pt) is formed to prevent the sample surface from being damaged by the ion beam. During such pretreatment of the analytical sample, carbon (C) may re-adhere to the processed cross-section of the sample and be included in the quantitative value as a part of the components constituting the analytical sample, and thus can be excluded from the components of the first layer 32 and the second layer 34 for obtaining the distribution ratio y(x). However, in a case where the first layer 32 is formed so as to be a $B_4C$ thin film, and the content distribution of carbon (C) is recognized to be dominant over measurement error, carbon (C) can be contained as a component of the first layer 32.

Then, an inflection point $x_1$, which is the position x at which the component dominance of the second layer 34 switches to the component dominance of the first layer 32, is determined. The inflection point $x_1$ can be regarded as the inflection point when the distribution ratio y(x) of a predetermined component is curve-fitted with a predetermined function. The inflection point $x_1$ can be considered to be the position of the interface between the first layer 32 and the second layer 34. As described above, the elements (components) of the first layer 32 and the second layer 34 typically diffuse mutually, it is difficult to identify the interface between the first layer 32 and the second layer 34. However, determining the inflection point $x_1$ can identify the interface between the first layer 32 and the second layer 34. In the present description, the position of the inflection point $x_1$ may be referred to as the interface between the first layer 32 and the second layer 34. The inflection point $x_1$ can be found as follows.

First, the range of x is determined for curve fitting the distribution ratio y(x) of a predetermined component with respect to the position x in the thickness direction of the protective film 3 using a predetermined function. The range of x for curve fitting the distribution ratio y(x) can be determined as follows. In the following, the curve-fitted function is also shown as the distribution ratio y(x).

First, a function for curve fitting the distribution ratio y(x) is selected.

As a function for curve fitting the distribution ratio y(x), a sigmoidal function can be used. A sigmoidal function is generally utilized to approximate a sigmoidal profile. As the sigmoidal function, a higher order function of a cubic function or more, an error function, an exponential function, a sine function, or the like can be used.

As a function for curve fitting the distribution ratio y(x), for example, a quartic function illustrated in the formula (1) can be used. In the formula (1), a, b, c, d, and e are constants.

$$y(x) = ax^4 + bx^3 + cx^2 + dx + e \quad \cdots \quad (1)$$

Then, a range of x (a start point and an end point of x) for curve fitting the distribution ratio y(x) by a predetermined function is determined. In the case of curve fitting the distribution ratio y(x), the start point of the curve fitting (origin of the position x in the film thickness direction) is set to the position of x = 0 (origin), and the end point of the curve fitting is set to the position of x = D. The position (depth) of x = D in the protective film 3 is closer to the interface between the protective film 3 and the multilayer reflective film than the position (depth) of x = 0. The start point (x = 0) in the protective film 3 can be a position (depth) at which the total content (atom%) of the Em element and the Ea element is the maximum value among the contents of the respective components. In addition, the position of x = D in the protective film 3 (the end point of the range of fitting) can be a position (depth) at which the determination coefficient $R^2$ of curve fitting by a predetermined function becomes the maximum value in the range of x in which the total content (atom%) of the Em element and the Ea element decreases from the maximum value and becomes 5 atom% or more and 20 atom% or less. The range of x from x = 0 to x = D is considered to include the interface between the first layer 32 and the second layer 34. A method of curve fitting is known.

Then, a predetermined function obtained by curve fitting the distribution ratio y(x) is second-order differentiated to provide a second derivative y"(x). The solution $x = x_1$ satisfying y''(x) = 0 is the inflection point $x_1$.

In a case where the function for curve fitting is a quartic function, the second derivative y"(x) obtained by second-order differentiation for obtaining the inflection point $x_1$ can be represented by the following formula (2).

$$y''(x) = 12ax^2 + 6bx + 2c \quad \cdots \quad (2)$$

In order to obtain the inflection point $x_1$ of the distribution ratio y(x), when a solution of y"(x) = 0 is obtained in the formula (2), the formula (3) is obtained.

$$x_1 = [-3b \pm (9b^2 - 24ac)^{0.5}]/(12a) \quad \cdots \quad (3)$$

y''(x) is a quadratic function, and thus there are two solutions of y"(x) = 0 as is clear from the formula (3). In this case, the distribution ratio y(x) is subjected to curve fitting with a cubic function, and a solution that satisfies the second derivative y''(x) = 0 of the quartic function, which is closer to the value of x of the solution in which the linear function which is the second derivative obtained by second-order differentiation of the cubic function becomes zero, can be the inflection point $x_1$.

The inflection point $x_1$ obtained as described above indicates the position x (the depth of the protective film 3 in the film thickness direction) at which the component dominance of the second layer 34 is switched to the component dominance of the first layer 32. In the protective film 3 of the present embodiment, at the position of the inflection point $x_1$, when the content of the metal element Em is M (atom%) and the content of the additive element Ea is A (atom%), the ratio A/M at the inflection point $x_1$ is 0.020 or more, preferably 0.022 or more. When the protective film 3 contains a plurality of metal elements Em, the content M of the metal elements Em is the sum of the contents (atom%) of the plurality of metal elements Em. In addition, if the protective film 3 contains a plurality of additive elements Ea, the content A of the additive elements Ea is the sum of the contents (atom%) of the plurality of additive elements Ea.

As described above, the protective film 3 of the present embodiment in which the ratio A/M at the inflection point $x_1$ is 0.020 or more when the content of the metal element Em is M (atom%) and the content of the additive element Ea is A (atom%) at the position of the inflection point $x_1$ may be referred to as a first aspect of the protective film 3 of the present embodiment in the present description.

It can be said that the inflection point $x_1$ corresponds to the interface between the first layer 32 and the second layer 34. The ratio A/M at the inflection point $x_1$ is equal to or more than the predetermined ratio, whereby the additive element Ea having a content equal to or more than the predetermined content is present at the interface between the first layer 32 and the second layer 34 as compared with the content of the metal element Em. The protective film 3 of the present embodiment has such distribution of the contents of the metal element Em and the additive element Ea, thereby allowing to improve adhesion between the first layer 32 and the second layer 34.

In the substrate with a multilayer reflective film 90 of the present embodiment, the ratio A/M at the inflection point $x_1$ is preferably less than 0.17, more preferably 0.16 or less, and still more preferably 0.12 or less. The upper limit of the ratio A/M is the predetermined value, thereby allowing to suppress an adverse effect on the reflectance of the substrate with a multilayer reflective film 90 due to the excessively large content A of the additive element Ea.

The value ($y'(x_1)$) at $x_1$ of the first derivative $y'(x)$ of $y(x)$ means the slope of $y(x)$ at position $x_1$. In a case where $y(x)$ is a quartic function, the inclination ($y'(x_1)$) of $y(x)$ at the position $x_1$ can be represented by the following formula (4).

$$y'\,(x_1)\ =\ 4ax_1{}^3 + 3bx_1{}^2 + 2cx_1 + d\ \cdot\cdot\cdot\ (4)$$

As the inclination $y'(x_1)$ is larger, the composition change at the interface between the first layer 32 and the second layer 34 is steeper, which means that the degree of diffusion of the component (element) at the interface between the first layer 32 and the second layer 34 is smaller. In the protective film 3 of the present embodiment, the gradient $y'(x_1)$ of the distribution ratio $y(x)$ is preferably large.

In the protective film 3 of the substrate with a multilayer reflective film 90 of the present embodiment, the content A of the additive element Ea at the inflection point $x_1$ is preferably 1 atom% or more and 15 atom% or less, and more preferably 1.5 atom% or more and 10 atom% or less. The content A of the additive element Ea at the inflection point $x_1$ is within the predetermined range, thereby allowing to improve the adhesion between the first layer 32 and the second layer 34.

In the protective film 3 of the substrate with a multilayer reflective film 90 of the present embodiment, the content M of the metal element Em at the inflection point $x_1$ is preferably 5 atom% or more and 80 atom% or less, and more preferably 10 atom% or more and 75 atom% or less. The content M of the metal element Em at the inflection point $x_1$ is within the predetermined range, thereby allowing to provide the protective film 3 having high etching resistance.

In the protective film 3 of the substrate with a multilayer reflective film 90 of the present embodiment, the first layer 32 contains silicon (Si) and at least one selected from nitrogen (N) and oxygen (O), and the total content of nitrogen (N) and oxygen (O) at the inflection point $x_1$ is preferably 2 atom% or more, and more preferably 4 atom% or more. At the inflection point $x_1$ corresponding to the interface between the first layer 32 and the second layer 34, the contents of nitrogen (N) and oxygen (O) are equal to or more than the predetermined amount, thereby allowing to suppress an adverse effect caused by diffusion of the element (for example, Si) of the component of the first layer 32 into the second layer 34.

In the protective film 3 of the substrate with a multilayer reflective film 90 of the present embodiment, the total content of nitrogen (N) and oxygen (O) at the inflection point $x_1$ is preferably 35 atom% or less, and more preferably 30 atom% or less. If the content of nitrogen (N) and/or oxygen (O) at the interface between the first layer 32 and the second layer 34 is too large, film peeling may occur at the interface between the first layer 32 and the second layer 34. Therefore, the total content of nitrogen (N) and oxygen (O) at the inflection point $x_1$ is preferably equal to or less than a predetermined amount.

The film thickness of the first layer 32 is preferably 1.0 to 2.0 nm, and more preferably 1.2 to 1.5 nm. In addition, the film thickness of the second layer 34 is preferably 1.5 to 5.0 nm, and more preferably 2.0 to 4.0 nm. The film thickness of the first layer 32 and the second layer 34 described above is a film thickness in a case where it is assumed that the interface between the first layer 32 and the second layer 34 is located at the inflection point $x_1$ described above.

The total film thickness (sometimes simply referred to as "the film thickness of the protective film 3") of the protective film 3 including the first layer 32 and the second layer 34 in the protective film 3 is not particularly limited as long as it can function as the protective film 3. From the viewpoint of the reflectance of the EUV light, the film thickness of the protective film 3 is preferably 1.0 nm to 8.0 nm, and more preferably 1.5 nm to 6.0 nm.

In addition, the contents of the components (the metal element Em, the additive element Ea, and the like) contained in the first layer 32 and the second layer 34 described above can be contents such that a composition gradient continuously changes in the film thickness direction (depth direction) of each layer.

In the substrate with a multilayer reflective film 90 of the present embodiment, heat treatment can be performed after the protective film 3 is formed or after the absorber film 4 is formed to provide the reflective mask blank 100. In this heat treatment, heating can be performed at a temperature higher than the prebaking temperature (about 110°C) of the resist film 11 in the manufacturing step of the reflective mask blank 100. Specifically, the temperature condition of the heat treatment is typically 130°C or more and 300°C or less, and preferably 150°C or more and 250°C or less. The heat treatment can adjust the stress of the substrate 1 and the thin film (the protective film 3 and the like) formed on the substrate 1. The substrate with a multilayer reflective film 90 and the reflective mask blank 100 of the present embodiment can suppress reduction in reflectance of the multilayer reflective film 2 with respect to EUV light even if heat treatment is performed.

The protective film 3 of the present embodiment can further include layers other than the first layer 32 and the second layer 34 described above as necessary.

In some cases, the above heat treatment can provide the second layer 34 having a more preferable composition for promoting diffusion of nitrogen contained in the second layer 34 and suppressing diffusion of Si into the second layer 34.

<<<Second aspect of protective film 3>>>

Then, a second aspect of the protective film 3 of the substrate with a multilayer reflective film 90 of the present embodiment will be described.

The protective film 3 of the second aspect of the present embodiment includes the first layer 32 and the second layer 34 similarly to the above-described first aspect. Similarly to the above-described aspect, the protective film 3 of the second aspect has an inflection point $x_1$ that is a position x at which the component dominance of the second layer 34 is switched to the component dominance of the first layer 32. In addition, in the protective film 3 of the second aspect, when the content of the metal element Em is M and the content of the additive element Ea is A, the ratio A/M at the inflection point $x_1$ and the total content (atom%) of nitrogen (N) and oxygen (O) at the inflection point $x_1$ have a specific relationship. The protective film 3 of the second aspect of the present embodiment contains nitrogen (N) and/or oxygen (O).

Specifically, in the graph where the ratio A/M at the inflection point $x_1$ is set to the Y axis as Y and the total content (atom%) of nitrogen (N) and oxygen (O) is set to the X axis as X, the protective film 3 satisfies the following conditions of the formulas (2-1) and (2-2), thereby allowing to enhance both the effects of improving the diffusion preventing effect of the components (in particular, the components constituting the first layer 32) constituting the protective film 3 and improving the adhesion between the first layer 32 and the second layer 34.

$$Y \geq -0.0233X + 0.14 \quad \cdots \quad (2\text{-}1)$$

and

$$Y \geq 0.0096X - 0.144 \quad \cdots \quad (2\text{-}2)$$

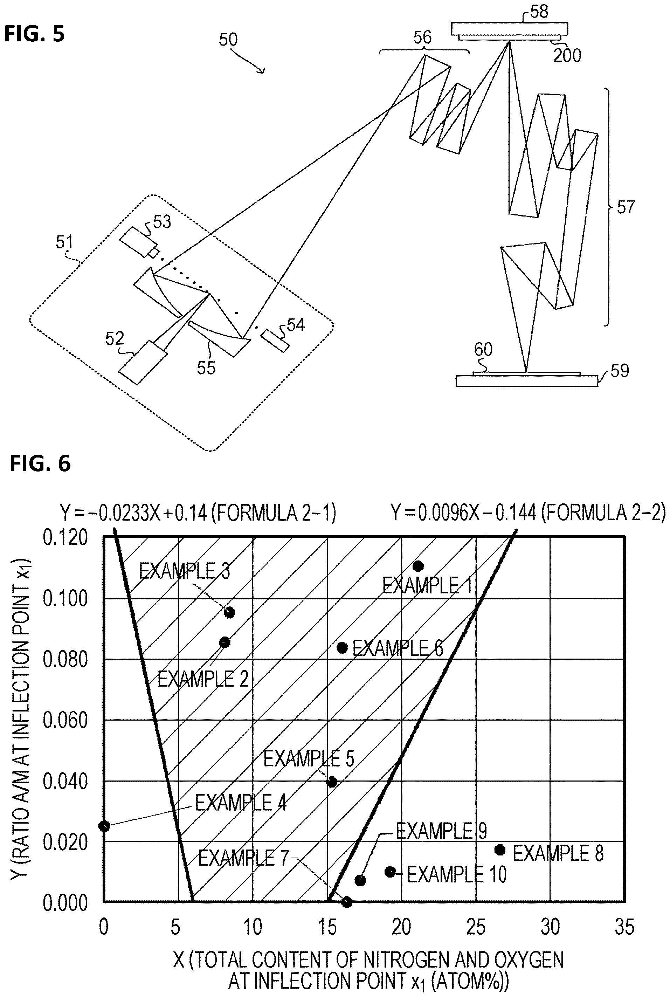

Fig. 6 is a view for explaining the relationship between the total content (atom%) (X axis) of nitrogen (N) and oxygen (O) at the inflection point $x_1$ and the ratio A/M (Y axis) of the content M of the metal element Em and the content A of the additive element Ea in the second aspect of the protective film 3 of the present embodiment. A hatched region between the straight line of the formula (2-1) and the straight line of the formula (2-2) in Fig. 6 is a region of X and Y satisfying the relationships of the formulas (2-1) and (2-2). In Fig. 6, for reference, values of X and Y in Examples 1 to 10 described later are plotted.

In the protective film 3 of the second aspect of the present embodiment, the ratio A/M (= Y) at the inflection point $x_1$ is not necessarily 0.020 or more.

In the protective film 3 according to the second aspect of the present embodiment, Y as the ratio A/M is zero or more (Y ≥ 0). This is because the content M of the metal element Em and the content A of the additive element Ea do not become negative values.

In addition, in the protective film 3 according to the second aspect of the present embodiment, the ratio A/M (= Y) at the inflection point $x_1$ is preferably less than 0.17, more preferably 0.16 or less, and still more preferably 0.12 or less. The upper limit of the ratio A/M (= Y) is the predetermined value, thereby allowing to suppress an adverse effect on the reflectance of the substrate with a multilayer reflective film 90 due to the excessively large content A of the additive element Ea.

The above-described formulas (2-1) and (2-2) were obtained as follows.

First, it is considered that as the deviation between the Fermi level of the component contained in the first layer 32 and the Fermi level of the component contained in the second layer 34 of the protective film 3 of the second aspect is larger, diffusion of the component (element) into each other layer is less likely to occur at the interface between the first layer 32 and the second layer 34. In addition, the Fermi level for the additive element Ea is relatively large, is smaller for the metal element Em and silicon nitride in this order, and is smallest for silicon oxide. Therefore, the Fermi level of the material containing nitrogen (N) and/or oxygen (O) is relatively smaller than the Fermi levels of the additive element Ea and the metal element Em, and thus it is considered that the diffusion-preventing performance is improved by using the material containing nitrogen (N) and/or oxygen (O). Therefore, the critical conditions for obtaining the desired diffusion-preventing performance should be defined by [A/M] = a * [content of nitrogen (N) + content of oxygen (O)] + b, described by the negative slope a and the positive intercept b. In order to avoid confusion between the multiplication symbol and the alphabet "x", the multiplication symbol is indicated by "*" herein. As a result of investigation based on some experimental results, the present inventors have found that the slope a and the intercept b of the formula of the critical condition are a = -0.0233 and b = 0.14, and obtained the formula (2-1).

Then, it is considered that as the deviation between the Fermi level of the component contained in the first layer 32 and the Fermi level of the component contained in the second layer 34 of the protective film 3 of the second aspect is larger, the adhesion at the interface between the first layer 32 and the second layer 34 is more deteriorated. In addition, the Fermi level for the additive element Ea is relatively large, is smaller for the metal element Em and silicon nitride in this order, and is smallest for silicon oxide. Therefore, the Fermi level of the material containing nitrogen (N) and/or oxygen (O) is relatively smaller than the Fermi level of the additive element Ea and the metal element Em, and thus it is considered that the adhesion at the interface between the first layer 32 and the second layer 34 is deteriorated by using the material containing nitrogen (N) and/or oxygen (O). On the other hand, the additive element Ea can form a coordinate bond with nitrogen (N) and oxygen (O), and thus it is considered that even if the content of nitrogen (N) and/or oxygen (O) is large, as long as the ratio A/M is large, it is possible to achieve desired adhesion at the interface between the first layer 32 and the second layer **34**. Therefore, the critical conditions for obtaining the desired adhesion at the interface should be defined by [A/M] = a * [content of nitrogen (N) + content of oxygen (O)] + b, described by the positive slope a and the negative intercept b. In order to avoid confusion between the multiplication symbol and the alphabet "x", the multiplication symbol is indicated by "*" herein. As a result of investigation based on some experimental results, the present inventors have found that the slope a and the intercept b of the formula of the critical condition are a = 0.0096 and b = -0.144, and obtained the formula (2-2).

Therefore, in the protective film 3 according to the second aspect of the present embodiment, satisfying the above formulas (2-1) and (2-2) causes diffusion of components (elements) into each other layer at the interface between the first layer 32 and the second layer 34 to hardly occur, thereby allowing to provide desired adhesion at the interface between the first layer 32 and the second layer 34.

Based on the above explanation, the substrate with a multilayer reflective film 90 including the protective film 3 of the second aspect of the present embodiment can have the following configuration.

The substrate with a multilayer reflective film 90 including the protective film 3 according to the second aspect of the present embodiment is a substrate with a multilayer reflective film having a substrate, a multilayer reflective film provided on the substrate, and a protective film provided on the multilayer reflective film, in which

the protective film includes a first layer and a second layer, and the first layer is disposed between the second layer and the multilayer reflective film,

the protective film contains at least one metal element Em and at least one additive element Ea, and a content of the metal element Em in the second layer is larger than a content of the metal element Em in the first layer,

the metal element Em is an element having a Fermi level of -4.7 eV or less,

the additive element Ea is an element having a Fermi level of more than -4.7 eV,

the protective film further contains at least one selected from nitrogen (N) and oxygen (O),

in a content distribution of a component contained in the protective film with respect to a position x in a film thickness direction of the protective film, when a position x at which a component dominance of the second layer is switched from a component dominance of the first layer is an inflection point $x_1$, a content of the metal element Em is M, a content of the additive element Ea is A, a ratio A/M is Y, and a total content (atom%) of nitrogen (N) and oxygen (O) is X, Y that is a ratio A/M at the inflection point $x_1$ and X satisfy the following relationship.

$$Y \geq -0.0233X + 0.14 \quad \cdots \quad (2-1)$$

and

$$Y \geq 0.0096X - 0.144 \quad \cdots \quad (2-2)$$

<<<Third aspect of protective film 3>>>

Then, a third aspect of the protective film 3 of the substrate with a multilayer reflective film 90 of the present embodiment will be described.

The protective film 3 of the third aspect of the present embodiment contains the first layer 32 and the second layer 34 similarly to the first aspect and the second aspect described above. Similarly to the above-described these aspects, the protective film 3 of the third aspect has an inflection point $x_1$ that is a position x at which the component dominance of the second layer 34 is switched to the component dominance of the first layer 32. In addition, in the protective film 3 of the third aspect, the distribution ratio $y(x_1)$ (total content of components in the first layer 32 at inflection point $x_1$/total content of components in the first layer 32 and components in the second layer 34 at inflection point $x_1$) at the inflection point $x_1$ and the gradient $y'(x_1)$ of the distribution ratio $y(x_1)$ at the inflection point $x_1$ have a specific relationship.

Specifically, in the graph where the distribution ratio $y(x_1)$ at the inflection point $x_1$ is set to the X-axis as X and the gradient $y'(x_1)$ of the distribution ratio $y(x_1)$ is set to the Y axis as Y, the protective film 3 satisfies the condition of the following formula (3), whereby the reduction in the EUV reflectance due to the long-term exposure can be controlled to a desired level or less.

$$Y \leq -12.4 * X + 744 \quad \cdots \quad (3)$$

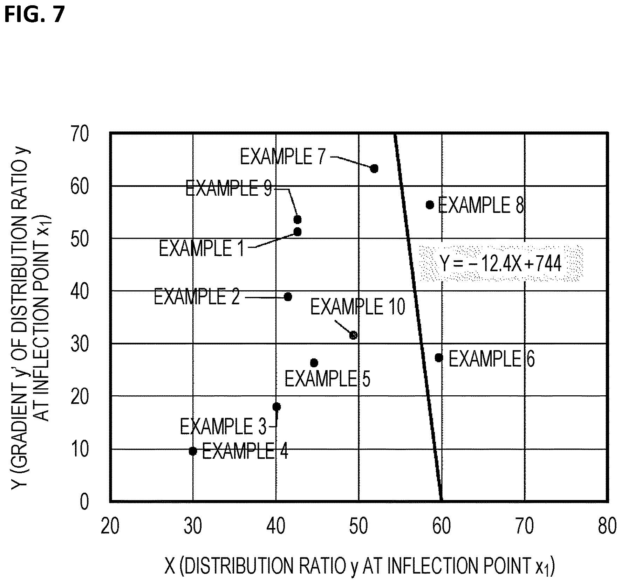

Fig. 7 is a view for explaining a relationship between a distribution ratio $y(x_1)$ (X axis) at an inflection point $x_1$ and a gradient $y'(x_1)$ (Y axis) of the distribution ratio $y(x_1)$ at the inflection point $x_1$ in the third aspect of the protective film 3 of the present embodiment. A region on the left side of the straight line of the formula (3) in Fig. 7 is a region of X and Y satisfying the relationship of the formula (3). In Fig. 7, for reference, values of X and Y in Examples 1 to 10 described later are plotted, and Examples 1 to 5, 7, 9, and 10 satisfy the condition of the formula (3).

The above formula (3) was determined as follows.

First, in order to suppress exposure contamination such as deposition of a carbon film on a reflective mask during EUV exposure, a technique of introducing hydrogen gas into an atmosphere during exposure is adopted. The protective film 3 of the third aspect contains the first layer 32 and the second layer 34, and under such an exposure environment, as the compositions of the first layer 32 and the second layer 34 are closer (hereinafter, referred to as "high homogeneity"), the phenomenon that hydrogen permeates from the second layer 34 to the first layer 32 is likely to occur. In addition, the homogeneity of the first layer 32 and the second layer 34 depends on the distribution ratio $y(x_1)$ at the inflection point $x_1$, and as the distribution ratio $y(x_1)$ is larger, the homogeneity is higher, and hydrogen easily permeates the first layer 32. As a result, as the distribution ratio $y(x_1)$ is larger, the EUV reflectance is more likely to reduce due to long-term exposure. In contrast, if the rate of change in the distribution ratio at the inflection point $x_1$, that is, the slope $y'(x_1)$ is large, the properties of each of the first layer 32 and the second layer 34 are clearly separated, and as a result permeation of hydrogen in an exposure environment can be prevented and reduction in EUV reflectance can be suppressed. Therefore, the reduction trend of EUV reflectance due to long-term exposure indicates a negative correlation with the distribution ratio $y(x_1)$ and a positive correlation with $y'(x_1)$. That is, the EUV reflectance is likely to reduce as $y(x_1)$ increases, and the EUV reflectance is less likely to reduce as $y'(x_1)$ increases. As a result of investigation based on some experimental results, the present inventors have found that it is necessary to satisfy the above formula (3) in order to control the reduction in EUV reflectance due to long-term exposure to a desired level or less.

Therefore, in the protective film 3 according to the third aspect of the present embodiment, satisfying the above formula (3) causes a phenomenon in which hydrogen permeates from the second layer 34 to the first layer 32 to be less likely to occur, and allows reduction in EUV reflectance due to long-term exposure to be less likely to occur.

Based on the above explanation, the substrate with a multilayer reflective film 90 including the protective film 3 of the third aspect of the present embodiment can have the following configuration.

The substrate with a multilayer reflective film 90 including the protective film 3 according to the third aspect of the present embodiment is a substrate with a multilayer reflective film including a substrate, a multilayer reflective film provided on the substrate, and a protective film provided on the multilayer reflective film,

the protective film includes a first layer and a second layer, and the first layer is disposed between the second layer and the multilayer reflective film,
the protective film contains at least one metal element Em and at least one additive element Ea, and a content of the metal element Em in the second layer is larger than a content of the metal element Em in the first layer,
the metal element Em is an element having a Fermi level of -4.7 eV or less,
the additive element Ea is an element having a Fermi level of more than -4.7 eV,
in a content distribution of a component contained in the protective film with respect to a position x in a film thickness direction of the protective film, when a position x at which a component dominance of the second layer is switched to a component dominance of the first layer is defined as an inflection point $x_1$, a distribution ratio (total content of components of the first layer at the inflection point $x_1$/total content of components of the first layer and components of the second layer at the inflection point $x_1$) at the inflection point $x_1$ is X, and a gradient of X is Y, X and Y satisfy the following relationship:

$$Y \leq -12.4 * X + 744.$$

<<Back conductive film 5>>

The substrate with a multilayer reflective film 90 of the present embodiment can have a back conductive film 5 for an electrostatic chuck. The back conductive film 5 can be formed on the second main surface (back main surface) of the substrate 1 (on the side opposite to the surface on which the multilayer reflective film 2 is formed, and on an intermediate layer if the intermediate layer such as a hydrogen infiltration suppression film is formed on the substrate 1). The sheet resistance required for the back conductive film 5 for an electrostatic chuck is typically 100 Ω/□ (Ω/square) or less. The method for forming the back conductive film 5 is, for example, the magnetron sputtering method or the ion beam sputtering method using a target of a metal such as chromium or tantalum or an alloy thereof. The material containing chromium (Cr) of the back conductive film 5 is preferably a Cr compound containing at least one selected from boron, nitrogen, oxygen, and carbon in Cr. Examples of the Cr compound include CrN, CrON, CrCN, CrCON, CrBN, CrBON, CrBCN, and CrBOCN. As the material containing tantalum (Ta) of the back conductive film 5, Ta (tantalum), an alloy containing Ta, or a Ta compound containing at least one of boron, nitrogen, oxygen, and carbon in any of these is preferably used. Examples of the Ta compound include TaB, TaN, TaO, TaON, TaCON, TaBN, TaBO, TaBON, TaBCON, TaHf, TaHfO, TaHfN, TaHfON, TaHfCON, TaSi, TaSiO, TaSiN, TaSiON, and TaSiCON. The film thickness of the back conductive film 5 is not particularly limited as long as the function as an electrostatic chuck is satisfied, but is typically 10 nm to 200 nm. In addition, the back conductive film 5 serves to adjust stress on the second main surface side of the mask blank 100. That is, the back conductive film 5 serves to adjustment so as to provide a flat reflective mask blank 100 by taking a balance with stress from various films formed on the first main surface side.

The substrate with a multilayer reflective film 90 does not necessarily contain the back conductive film 5. For example, after the absorber film 4 to be described later is formed, the back conductive film 5 can be formed on the reflective mask blank 100.

<Reflective mask blank 100>

The reflective mask blank 100 of the present embodiment will be described. As illustrated in Fig. 2, the reflective mask blank 100 of the present embodiment has the absorber film 4 on the protective film 3 of the substrate with a multilayer reflective film 90 described above.

<<Absorber film 4>>

The absorber film 4 of the reflective mask blank 100 of the present embodiment is formed on the protective film 3. A basic function of the absorber film 4 is to absorb EUV light. The absorber film 4 may be an absorber film 4 for the purpose of absorbing EUV light, or may be an absorber film 4 having a phase shift function in consideration of a phase difference of EUV light. The absorber film 4 having a phase shift function is one that absorbs EUV light and reflects a part of the EUV light to shift the phase. That is, in the reflective mask 200 in which the absorber film 4 having the phase shift function is patterned, a portion where the absorber film 4 is formed reflects a part of light at a level that does not adversely affect pattern transfer while absorbing and attenuating EUV light. In addition, in a region (field portion) where the absorber film 4 is not formed, the EUV light is reflected from the multilayer reflective film 2 via the protective film 3. Therefore, a desired phase difference is provided between the reflected light from the absorber film 4 having the phase shift function and the reflected light from the field portion. The absorber film 4 having the phase shift function is formed such that the phase difference between the reflected light from the absorber film 4 and the reflected light from the multilayer reflective film 2 is 170 degrees to 260 degrees. The light having the inverted phase difference interfere with each other at the pattern edge portion, thereby improving the image contrast of the projection optical image. As the image contrast is improved, the resolution is increased, and various tolerances regarding exposure such as exposure tolerance and focus tolerance can be increased.

The absorber film 4 may be a single-layer film or a multilayer film including a plurality of films (for example, a lower absorber film (buffer layer) and an upper absorber film). The single-layer film has a feature that the number of steps during manufacturing the mask blank can be reduced and the manufacturing efficiency is increased. In the case of a multilayer film, the optical constant and film thickness thereof can be appropriately set such that the upper absorber film becomes an antireflective film during mask pattern defect inspection using light. This improves inspection sensitivity during mask pattern defect inspection using light. In addition, a film to which oxygen (O), nitrogen (N), or the like providing improved oxidation resistance is added is used as the upper absorber film, thereby improving temporal stability. Thus, various functions can be added by forming the absorber film 4 into a multilayer film. In a case where the absorber film 4 is the absorber film 4 having a phase shift function, the range of adjustment on the optical surface can be widened by forming the absorber film 4 into a multilayer film, thus easily providing a desired reflectance.

The material of the absorber film 4 is not particularly limited as long as it has a function of absorbing EUV light, can be processed by etching or the like (preferably, etching can be performed by dry etching by a chlorine (Cl)-based gas and/or a fluorine (F)-based gas), and has a high etching selectivity ratio to the protective film 3 (second layer 34). As those having such a function, at least one metal selected from palladium (Pd), silver (Ag), platinum (Pt), gold (Au), iridium (Ir), tungsten (W), chromium (Cr), cobalt (Co), manganese (Mn), tin (Sn), tantalum (Ta), vanadium (V), nickel (Ni), hafnium (Hf), iron (Fe), copper (Cu), tellurium (Te), zinc (Zn), magnesium (Mg), germanium (Ge), aluminum (Al), rhodium (Rh), ruthenium (Ru), molybdenum (Mo), niobium (Nb), titanium (Ti), zirconium (Zr), yttrium (Y), and silicon (Si), an alloy containing two or more metals, or a compound thereof can be preferably used. The compound may contain oxygen (O), nitrogen (N), carbon (C), and/or boron (B) in the metal or alloy.

The absorber film 4 can be formed by the magnetron sputtering method such as the DC sputtering method and the RF sputtering method. For example, the absorber film 4 such as a tantalum compound can be formed by the reactive sputtering method using a target containing tantalum and boron and using an argon gas to which oxygen or nitrogen is added.

In addition, from the viewpoint of smoothness and flatness, the crystalline state of the absorber film 4 is preferably an amorphous or microcrystalline structure. If the surface of the absorber film 4 is not smooth and flat, the edge roughness of the absorber pattern 4a increases, and the dimensional accuracy of the pattern may deteriorate. The surface roughness of the absorber film 4 is preferably 0.5 nm or less, more preferably 0.4 nm or less, and still more preferably 0.3 nm or less in root mean square roughness (Rms).

In the present embodiment, even if the reflective mask blank 100 having a structure in which the protective film 3 made of a material containing metal is disposed on the high refractive index layer is subjected to heat treatment, it is possible to obtain the reflective mask blank 100 capable of suppressing reduction in reflectance of the multilayer reflective film 2 with respect to EUV light.

<<Etching mask film 6>>

As illustrated in Fig. 3, the reflective mask blank 100 of the present embodiment may have an etching mask film 6 on the absorber film 4. As the material of the etching mask film 6, a material having a high etching selectivity ratio of the absorber film 4 to the etching mask film 6 (etching speed of the absorber film 4/etching speed of the etching mask film 6) is preferably used. The etching selectivity ratio of the absorber film 4 to the etching mask film 6 is preferably 1.5 or more, and more preferably 3 or more.

The reflective mask blank 100 of the present embodiment preferably has the etching mask film 6 on the absorber film 4.

As a material of the etching mask film 6, chromium or a chromium compound is preferably used. Examples of the chromium compound include a material containing Cr and at least one element selected from N, O, C, and H. The etching mask film 6 more preferably contains CrN, CrO, CrC, CrON, CrOC, CrCN, or CrOCN, and still more preferably is a CrO-based film (CrO film, CrON film, CrOC film, or CrOCN film) containing chromium and oxygen.

As a material of the etching mask film 6, tantalum or a tantalum compound is preferably used. Examples of the tantalum compound include a material containing Ta and at least one element selected from N, O, B, and H. The etching mask film 6 more preferably contains TaN, TaO, TaON, TaBN, TaBO, or TaBON.

As a material of the etching mask film 6, silicon or a silicon compound is preferably used. Examples of the silicon compound include a material containing Si and at least one element selected from N, O, C, and H, metal silicon (metal silicide) containing metal in silicon and a silicon compound, and a metal silicon compound (metal silicide compound). Examples of the metal silicon compound include a material containing a metal, Si, and at least one element selected from N, O, C, and H.

The film thickness of the etching mask film 6 is preferably 3 nm or more in order to form a pattern on the absorber film 4 with high accuracy. In addition, the film thickness of the etching mask film 6 is preferably 15 nm or less in order to reduce the film thickness of the resist film 11.

<Reflective mask 200>

The present embodiment is the reflective mask 200 including the absorber pattern 4a obtained by patterning the absorber film 4 of the above-described reflective mask blank.

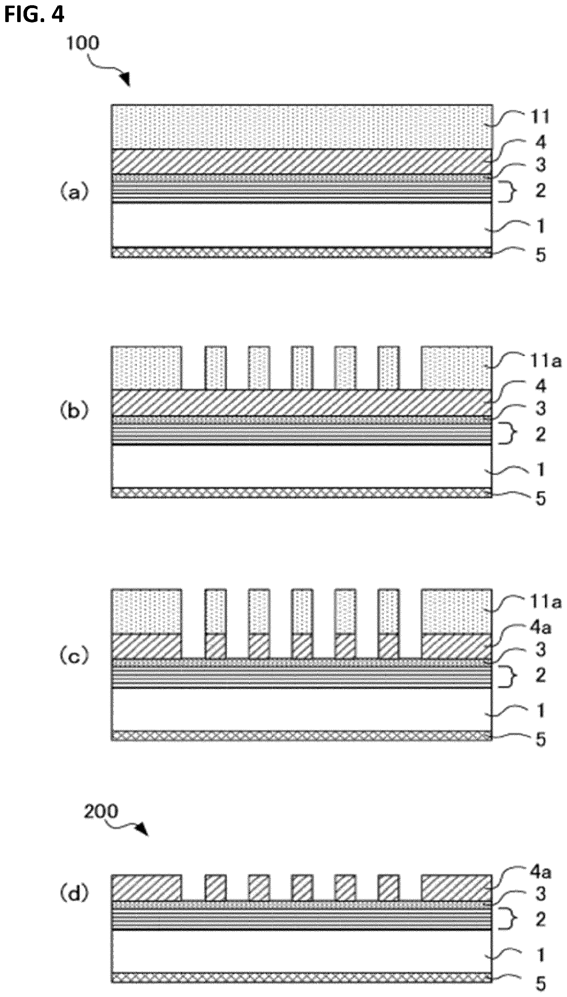

As illustrated in Fig. 4(d), the reflective mask 200 of the present embodiment includes an absorber pattern 4a obtained by patterning the absorber film 4 of the reflective mask blank 100 described above.

Figs. 4(a) to 4(d) are schematic diagrams illustrating an example of a method for manufacturing the reflective mask 200. The reflective mask 200 of the present embodiment can be manufactured using the above-described reflective mask blank 100 of the present embodiment. Hereinafter, an example of a method for manufacturing the reflective mask 200 will be described.

First, there is prepared a reflective mask blank 100 having the substrate 1, the multilayer reflective film 2 formed on the substrate 1, the protective film 3 formed on the multilayer reflective film 2, and the absorber film 4 formed on the protective film 3. Then, the resist film 11 is formed on the absorber film 4 to provide the reflective mask blank 100 with the resist film 11 (Fig. 4(a)). A pattern is written on the resist film 11 by an electron beam lithography apparatus, and further subjected to a development and rinsing step to form a resist pattern 11a (Fig. 4(b)).

The absorber film 4 is dry-etched using the resist pattern 11a as a mask. As a result, a portion of the absorber film 4 not covered with the resist pattern 11a is etched to form the absorber pattern 4a (Fig. 4(c)).

As the etching gas of the absorber film 4, for example, a fluorine-based gas and/or a chlorine-based gas can be used. As the fluorine-based gas, $CF_4$, $CHF_3$, $C_2F_6$, $C_3F_6$, $C_4F_6$, $C_4F_8$, $CH_2F_2$, $CH_3F$, $C_3F_8$, $SF_6$, $F_2$, and the like can be used. As the chlorine-based gas, $Cl_2$, $SiCl_4$, $CHCl_3$, $CCl_4$, $BCl_3$, and the like can be used. In addition, a mixed gas containing a fluorine-based gas and/or a chlorine-based gas and $O_2$ in a predetermined ratio can be used. These etching gases can further include an inert gas such as He and/or Ar as necessary.

After the absorber pattern 4a is formed, the resist pattern 11a is removed with a resist stripping solution. After the resist pattern 11a is removed, the reflective mask 200 of the present embodiment can be obtained through a wet cleaning step using an acidic or alkaline aqueous solution (Fig. 4(d)).

In a case of using the reflective mask blank 100 in which the etching mask film 6 is formed on the absorber film 4, there is added a step of forming a pattern (etching mask pattern) on the etching mask film 6 using the resist pattern 11a as a mask and then forming a pattern on the absorber film 4 using the etching mask pattern as a mask.

The reflective mask 200 thus obtained has a structure in which the multilayer reflective film 2, the protective film 3, and the absorber pattern 4a are laminated on the substrate 1.

A region (reflection region) where the multilayer reflective film 2 covered with the protective film 3 is exposed has a function of reflecting EUV light. A region where the multilayer reflective film 2 and the protective film 3 are covered with the absorber pattern 4a has a function of absorbing EUV light. The reflective mask 200 of the present embodiment can suppress reduction in the reflectance of the reflective region with respect to the EUV light even if heat treatment is performed. Using the reflective mask 200 of the present embodiment can provide a reflective region that maintains a high reflectance to EUV light, and thus a finer pattern can be transferred to the transfer object in EUV lithography.

In the reflective mask 200 of the present embodiment, the adhesion of the interface between the first layer 32 and the second layer 34 of the protective film 3 can be improved. Therefore, occurrence of film peeling defects of the reflective mask 200 of the present embodiment can be suppressed. In addition, in the reflective mask 200 of the present embodiment, the adhesion of the interface between the first layer 32 and the second layer 34 of the protective film 3 can be improved, a high reflectance for EUV light can be maintained, and high etching resistance of the protective film 3 can be maintained. Therefore, the reflective mask 200 of the present embodiment can be used for manufacturing a high-performance semiconductor device.

<Method for manufacturing semiconductor device>

The method for manufacturing a semiconductor device according to the present embodiment includes a step of performing a lithography process using an exposure apparatus using the above-described reflective mask 200 to form a transfer pattern on a transfer object.

A transfer pattern can be formed on the semiconductor substrate 60 (transfer object) by lithography using the reflective mask 200 of the present embodiment. This transfer pattern has a shape to which the pattern of the reflective mask 200 is transferred. A semiconductor device can be manufactured by forming a transfer pattern on the semiconductor substrate 60 by the reflective mask 200.

The present embodiment can manufacture a semiconductor device by using the substrate with a multilayer reflective film 90 capable of suppressing reduction in reflectance of the multilayer reflective film 2 with respect to EUV light even when heat treatment is performed, and the reflective mask 200 formed using the reflective mask blank 100 as a raw material. Therefore, using the reflective mask 200 of the present embodiment can increase the density and accuracy of the semiconductor device.

A method for transferring a pattern to the semiconductor substrate 60 with resist by EUV light will be described with reference to Fig. 5.

Fig. 5 shows a schematic configuration of an EUV exposure apparatus 50 that is an apparatus for transferring a transfer pattern to the resist film 11 formed on the semiconductor substrate 60. In the EUV exposure apparatus 50, an EUV light generation unit 51, an irradiation optical system 56, a reticle stage 58, the projection optical system 57, and the wafer stage 59 are precisely disposed along the optical path axis of the EUV light. The container of the EUV exposure apparatus 50 is filled with hydrogen gas.

The EUV light generation unit 51 includes a laser light source 52, a tin droplet generation unit 53, a catching unit 54, and a collector 55. When the tin droplets emitted from the tin droplet generation unit 53 are irradiated with a high-power carbon dioxide laser from the laser light source 52, tin in a droplet state is turned into plasma, and EUV light is generated.

The generated EUV light is collected by the collector 55, passes through the irradiation optical system 56, and enters the reflective mask 200 set on the reticle stage 58. The EUV light generation unit 51 generates, for example, EUV light having a wavelength of 13.53 nm.

The EUV light reflected by the reflective mask 200 is typically reduced to about 1/4 to be pattern image light by the projection optical system 57 and projected on the semiconductor substrate 60 (transfer target substrate). As a result, a predetermined circuit pattern is transferred to the resist film on the semiconductor substrate 60. A resist pattern can be formed on the semiconductor substrate 60 by developing the exposed resist film. Etching the semiconductor substrate 60 using the resist pattern as a mask can form an integrated circuit pattern on the semiconductor substrate 60. Through such steps and other necessary steps, a semiconductor device is manufactured.

Examples

Examples 1 to 10 are described below. These examples are not intended to limit the invention.

As Examples 1 to 10, a substrate with a multilayer reflective film 90 in which the multilayer reflective film 2 and the protective film 3 were formed on a first main surface of the substrate 1 was prepared.

Table 1 shows the types of the Em element and the Ea element contained in the protective film 3 of Examples 1 to 10, the gas flow rate conditions during film formation of the second layer 34, and the continuity of the film formation process. The continuity of the film formation process indicates whether or not the second layer 34 is continuously formed in the film formation apparatus without being taken out to the atmosphere after the formation of the first layer 32. In addition, Table 1 shows the composition of the target for forming the second layer 34 of the protective film 3 of Examples 1 to 10.

The substrate with a multilayer reflective film 90 of Examples 1 to 10 was prepared as follows.

As the substrate 1, there was prepared a $SiO_2$-$TiO_2$-based glass substrate 1, which was a 6025 size (about 152 mm $\times$ 152 mm $\times$ 6.35 mm) low thermal expansion glass substrate 1 in which both surfaces of the first main surface and the second main surface were polished. Polishing including a rough polishing step, a precision polishing step, a local processing step, and a touch polishing step was performed so as to obtain a flat and smooth main surface.

Then, the multilayer reflective film 2 was formed on the first main surface of the substrate 1. The multilayer reflective film 2 was set to a periodic multilayer reflective film 2 made of Si and Mo in order to form the multilayer reflective film 2 suitable for EUV light having a wavelength of 13.5 nm. Specifically, a Si target and a Mo target were used as a target of a high refractive index material and a target of a low refractive index material. Krypton (Kr) ion particles were supplied from an ion source to these targets, and ion beam sputtering was performed to alternately laminate a Si layer and a Mo layer on the substrate 1.

Herein, the sputtered particles of Si and Mo were made incident at an angle of 30 degrees with respect to the normal line of the first main surface of the substrate 1. First, a Si layer was formed in a thickness of 4.2 nm, and subsequently, a Mo layer was formed in a thickness of 2.8 nm. This was regarded as 1 period, and 40 periods of lamination were performed in the same manner. Therefore, the material of the lowermost layer of the multilayer reflective film 2, that is, the material of the multilayer reflective film 2 closest to the substrate 1 is Si, and the material of the uppermost layer of the multilayer reflective film 2 is Mo.

Then, the protective film 3 including the first layer 32 and the second layer 34 was formed on the multilayer reflective film 2 of Examples 1 to 10.

First, the first layer 32 of the protective film 3 was formed on the surface of the multilayer reflective film 2. The first layer 32 was formed under the same conditions as in the method for forming the Si layer of the multilayer reflective film 2 described above. In this case, the first layer 32 was formed such that the thickness of the first layer 32 was 4.0 nm from the relationship between the film formation rate of the Si layer and the film formation time under a predetermined condition.

Then, the second layer 34 was formed on the surface of the first layer 32. Table 1 shows the continuity of the film formation process between the formation of the first layer 32 and the formation of the second layer 34. In the case described as "continuous" in Table 1, after the formation of the first layer 32, the sample was not taken out to the atmosphere, and the second layer 34 was continuously formed in the film formation apparatus. In addition, in the case described as "discontinuous" in Table 1, after the formation of the first layer 32, the sample was taken out to the atmosphere, and then the sample was placed in a film formation apparatus to form the second layer 34. The second layer 34 was formed by the DC magnetron sputtering method (reactive sputtering method) in a gas atmosphere introduced at a flow ratio $N_2$/Ar (flow unit sccm: Standard Cubic Centimeter per Minute) of a nitrogen ($N_2$) gas and/or an argon (Ar) gas shown in Table 1 using a sintered target having a composition shown in Table 1.

Then, the content of each component with respect to the position x in the film thickness direction (depth direction) of the protective film 3 (the first layer 32 and the second layer 34) of Examples 1 to 10 was measured to provide the content distribution of each component (element). The content distribution of each component was measured by energy dispersive X-ray spectroscopy (EDX) using a scanning transmission electron microscope (STEM).

Then, based on the measured values of the content of each component for the position x in the thickness direction of the protective film 3, the following distribution ratio y(x) for the position x was determined.

$y(x)$ = (the total content of components in the first layer 32 at the position $x$)/(the total content of components in the first layer 32 and the second layer 34 at the position $x$)

Then, the distribution ratio $y(x)$ was subjected to curve fitting with a quartic function to provide a quartic function $y(x)$ corresponding to the distribution ratio $y(x)$. A start point and an end point of $x$ for curve fitting were determined as follows. The start point of the curve fitting (origin of the position $x$ in the film thickness direction) was set to the position of $x = 0$ (origin), and the end point of the curve fitting is set to the position of $x = D$. The position (depth) of $x = D$ in the protective film 3 is closer to the interface between the protective film 3 and the multilayer reflective film than the position (depth) of $x = 0$.

The start point ($x = 0$) for curve fitting was set to a position (depth) at which the total content (atom%) of the Em element and the Ea element is the maximum value among the contents of the respective components. In addition, in the position of $x = D$ (the end point of the range of the curve fitting), in the range of $x$ in which the total content (atom%) of the Em element and the Ea element decreases from the maximum value and becomes 5 atom% or more and 20 atom% or less, the point $x$ at which the determination coefficient $R^2$ of the curve fitting by the quartic function becomes the maximum value in the range of $x$ is set as $x = D$. The range of $x$ from $x = 0$ to $x = D$ was set to a range in the film thickness direction (depth direction) considered to include the interface between the first layer 32 and the second layer 34. The distribution ratio $y(x)$ was subjected to curve fitting with a quartic function in the range from the start point ($x = 0$) to the end point ($x = D$) obtained as described above to provide a quartic function $y(x)$ corresponding to the distribution ratio $y(x)$.

The position corresponding to the interface between the first layer 32 and the second layer 34 was specified by obtaining the inflection point $x_1$ of the quartic function $y(x)$. The inflection point $x_1$ of the quartic function $y(x)$ was able to be obtained by determining a solution of $y''(x) = 0$ for the second-order derivative $y''(x)$ obtained by second-order differentiation of the quartic function $y(x)$.

Table 2 shows the content (atom%) of each element at the start point ($x = 0$) of the curve fitting. This value is the content at the position where the total content (atom%) of the Em element and the Ea element becomes the maximum value, and thus it can also be said that this value is the composition of the center of the second layer 34. Table 3 shows the total content (atom%) of the Em element and the Ea element at the start point ($x = 0$) of the curve fitting, the depth D (nm) in the film thickness direction which is the end point of the curve fitting, the maximum value of the determination coefficient $R^2$ of the curve fitting by the quartic function $y(x)$, the inflection point $x_1$ (nm) of the quartic function $y(x)$, the value of the first derivative of the quartic function $y(x)$ at the inflection point $x_1$ ($y'(x_1)$), and the value of the quartic function $y(x)$ at the inflection point $x_1$ ($y(x_1)$).

Table 4 shows the composition (atom%) at the inflection point $x_1$ (interface between the first layer 32 and the second layer 34), the total content (M + A) of the Em element and the Ea element, and the ratio (A/M) of the content M of the metal element Em to the content A of the additive element Ea.

(Measurement of reflectance to EUV light of substrate with a multilayer reflective film 90)

Using the substrate with a multilayer reflective film 90 of Examples 1 to 10 prepared as described above, the reflectance (unit: %) of the substrate with a multilayer reflective film 90 to EUV light was measured. Table 4 shows the measurement results of the reflectance (unit: %) with respect to the EUV light for the substrate with a multilayer reflective film 90 of Examples 1 to 10.

As shown in Table 4, the reflectance to the EUV light of the substrate with a multilayer reflective film 90 of Examples 1 to 10 was in the range of 62.9% (Example 3) to 64.2% (Example 9). Therefore, it can be said that all of the reflectance of the substrate with a multilayer reflective film 90 of Examples 1 to 10 with respect to the EUV light are high reflectance that can be used for the reflective mask 200.

As shown in Table 4, no film peeling defect was observed in the substrate with a multilayer reflective film 90 of Examples 1 to 6. The ratio (A/M) between the content M of the metal element Em and the content A of the additive element Ea at the inflection point $x_1$ (interface between the first layer 32 and the second layer 34) in Examples 1 to 6 is in the range of 0.024 to 0.110. In contrast, in the substrate with a multilayer reflective film 90 of Examples 7 to 10, film peeling defects were observed after formation of the absorber film 4 to be described later although the reflectance was high. The ratio (A/M) of the content M of the metal element Em to the content A of the additive element Ea at the inflection point $x_1$ in Examples 7 to 10 is in the range of 0 to 0.017.

As described above, in the substrate with a multilayer reflective film 90 of Examples 1 to 6 of the present embodiment having the protective film 3 of the first aspect, it can be said that the adhesion between the first layer 32 and the second layer 34 of the protective film 3 was able to be improved while maintaining high reflectance to EUV light.

In addition, as illustrated in Fig. 6, in the protective films 3 of Examples 1 to 3, 5, and 6 described above, the ratio A/M ($= Y$) at the inflection point $x_1$ (interface between the first layer 32 and the second layer 34) satisfies the formulas (2-1) and (2-1) of the second aspect of the present embodiment. Therefore, in the substrate with a multilayer reflective film 90 according to the second aspect of the present embodiment, it can be said that the adhesion between the first layer 32 and the second layer 34 of the protective film 3 was able to be improved while maintaining high reflectance to EUV light.

The Fermi level of the material containing nitrogen (N) and/or oxygen (O) is relatively smaller than the Fermi levels of the additive element Ea and the metal element Em, and thus it is considered that the diffusion-preventing performance is improved by using the material containing nitrogen (N) and/or oxygen (O). The protective films 3 of Examples 1 to 3, 5, and 6 contain nitrogen (N) and/or oxygen (O) at the position of the inflection point $x_1$ (interface between the first layer 32 and the second layer 34), and thus it is considered that the diffusion-preventing performance is improved. In contrast, the protective film 3 of Example 4 contains no detectable contents of nitrogen (N) and oxygen (O) at the position of the inflection point $x_1$ (interface between the first layer 32 and the second layer 34), and thus it is considered that the effect of the diffusion-preventing performance caused by nitrogen (N) and/or oxygen (O) as in Examples 1 to 3, 5, and 6 fails to be obtained.

As illustrated in Fig. 7, in the protective films 3 of Examples 1 to 5, 7, 9, and 10 described above, the distribution ratio (total content of components in the first layer 32 at the inflection point $x_1$/total content of components in the first layer 32 and components in the second layer 34 at the inflection point $x_1$) (= X) at the inflection point $x_1$ (interface between the first layer 32 and the second layer 34) and the rate of change in the distribution ratio at the inflection point $x_1$, that is, the gradient (= Y) satisfy the relationship of the formula (3) of the third aspect of the present embodiment. Therefore, in the substrate with a multilayer reflective film 90 according to the third aspect of the present embodiment, it can be said that the reduction in EUV reflectance due to long-term exposure was able to be controlled to a desired level or less.

(Reflective mask blank 100)

Then, the reflective mask blank 100 of Examples 1 to 10 will be described.

The back conductive film 5 was formed on the back surface of the substrate 1 of the substrate with a multilayer reflective film 90 manufactured under the same conditions as described above, and the absorber film 4 was formed on the protective film 3, thereby manufacturing the reflective mask blank 100 of Examples 1 to 10.

First, the back conductive film 5 made of a CrN film was formed on the second main surface (back surface) of the substrate 1 of the substrate with a multilayer reflective film 90 by the magnetron sputtering (reactive sputtering) method under the following conditions.

Conditions for forming the back conductive film 5: a Cr target, a mixed gas atmosphere of Ar and $N_2$ (Ar: 90%, $N_2$: 10%), and a film thickness of 20 nm.

Then, a TaBN film having a film thickness of 55 nm was formed as the absorber film 4 on the protective film 3 of the substrate with a multilayer reflective film 90. The composition of the absorber film 4 was Ta : B : N = 75 : 12 : 13 (atomic ratio), and the film thickness was 55 nm.

The reflective mask blank 100 of Examples was manufactured as described above.

(Method for detecting and determining film peeling defect of reflective mask blank 100)

Then, a method for detecting and determining a film peeling defect of the reflective mask blank 100 will be described. The film peeling defect is one detected by inspecting the surface of the absorber film 4, which is the outermost surface layer of the reflective mask blank 100, with a defect inspection apparatus capable of detecting a defect having a height of 4 nm or more and a width of 80 nm or more for the reflective mask blank 100. The detected defect group includes general defects that may occur in the manufacturing step of the reflective mask blank 100 due to the film formation step and the cleaning step in addition to the film peeling defect, and thus the presence or absence of the film peeling defect was determined by observing the cross section of these defects using a scanning transmission electron microscope (STEM). Table 4 shows the determination results of the presence or absence of the film peeling defect of the reflective mask blanks 100 of Examples 1 to 10.

(Reflective mask 200)

Then, the reflective mask 200 was manufactured using the reflective mask blank 100 of Examples 1 to 6 having no film peeling defect. The manufacture of the reflective mask 200 will be described with reference to Fig. 4.

First, as illustrated in Fig. 4(a), the resist film 11 was formed on the absorber film 4 of the reflective mask blank 100. Then, a desired pattern such as a circuit pattern was drawn (exposed) on the resist film 11, and further developed and rinsed to form a predetermined resist pattern 11a (Fig. 4(b)). Then, using the resist pattern 11a as a mask, the absorber film 4 (TaBN film) was dry-etched using $Cl_2$ gas to form an absorber pattern 4a (Fig. 4(c)). Thereafter, the resist pattern 11a was removed (Fig. 4(d)).

Finally, wet cleaning using pure water (DIW) was performed to manufacture the reflective mask 200 of Examples 1 to 6.

(Manufacture of semiconductor device)

The reflective mask 200 of Examples 1 to 6 was set in an EUV scanner, and EUV exposure was performed on a wafer on which a film to be processed and a resist film were formed on a semiconductor substrate 60 as a transfer object. Then, the exposed resist film was developed to form a resist pattern on the semiconductor substrate 60 on which the film to be processed was formed.

In the reflective mask 200 of Examples 1 to 6, the protective film 3 includes the predetermined first layer 32 and second layer 34, and thus it is considered that the adhesion between the first layer 32 and the second layer 34 was able to be improved. Therefore, using the reflective mask 200 of Examples 1 to 6, a fine and highly accurate transfer pattern (resist pattern) has been able to be formed on the semiconductor substrate 60 (transfer target substrate).

Transferring this resist pattern to a film to be processed by etching and passing through various steps such as formation of an insulating film and a conductive film, introduction of a dopant, and annealing, a semiconductor device having desired characteristics has been able to be manufactured at a high yield.

[Table 1]

| | Element in protective film | | Gas flow condition during formation of second layer | Continuity of film formation process | Composition ratio of target for formation of second layer (atom% ratio) |
|---|---|---|---|---|---|
| | Em element | Ea element | $N_2$ (sccm)/ Ar (sccm) | | |
| Example 1 | Ru, Rh | Cr | 30/0 | continuous | Ru : Rh : Cr = 60 : 30 : 10 |
| Example 2 | Ru, Rh | Cr | 20/10 | continuous | Ru : Rh : Cr = 60 : 30 : 10 |
| Example 3 | Ru, Rh | Cr | 10/20 | continuous | Ru : Rh : Cr = 60 : 30 : 10 |
| Example 4 | Ru, Rh | Nb | 0/30 | continuous | Ru : Rh : Nb = 50 : 40 : 10 |
| Example 5 | Ru | Nb | 10/10 | continuous | Ru : Nb = 85 : 15 |
| Example 6 | Ru | Nb | 0/15 | discontinuous | Ru : Nb = 85 : 15 |
| Example 7 | Ru, Rh | - | 30/0 | continuous | Ru : Rh = 70 : 30 |
| Example 8 | Ru, Rh | Cr | 30/0 | continuous | Ru : Rh : Cr = 65 : 30 : 5 |
| Example 9 | Ru, Rh | Nb | 30/0 | continuous | Ru : Rh : Nb = 55 : 40 : 5 |
| Example 10 | Ru | Nb | 10/10 | discontinuous | Ru : Nb = 92 : 8 |

[Table 2]

| | Content of each element at x = 0 | | | |
|---|---|---|---|---|
| | Ru content (atom%) | Rh content (atom%) | Cr content (atom%) | Nb content (atom%) |
| Example 1 | 58.0 | 29.1 | 4.4 | - |
| Example 2 | 48.1 | 21.5 | 5.2 | - |
| Example 3 | 52.8 | 23.7 | 6.3 | - |
| Example 4 | 46.4 | 35.6 | - | 1.5 |
| Example 5 | 74.1 | - | - | 4.7 |
| Example 6 | 65.1 | - | - | 6.8 |
| Example 7 | 61.4 | 23.4 | - | - |
| Example 8 | 52.4 | 20.8 | 3.0 | - |
| Example 9 | 48.8 | 31.5 | - | 0.6 |
| Example 10 | 81.0 | - | - | 0.8 |

[Table 3]

|  | Total content of Em element and Ea element at x = 0 (atom%) | Position (depth) x = D (nm) in film thickness direction as end point of curve fitting | Maximum value of determination coefficient $R^2$ of curve fitting | $x_1$ (nm) | $y'(x_1)$ | $y(x_1)$ |
|---|---|---|---|---|---|---|
| Example 1 | 91.5 | 3.2 | 0.988 | 1.29 | 51.1 | 42.7 |
| Example 2 | 74.8 | 3.2 | 0.988 | 1.27 | 38.8 | 41.5 |
| Example 3 | 82.8 | 6.0 | 0.973 | 1.76 | 17.9 | 40.2 |
| Example 4 | 83.5 | 4.7 | 0.995 | 1.51 | 9.5 | 30.1 |
| Example 5 | 78.8 | 4.6 | 0.977 | 0.97 | 26.2 | 44.7 |
| Example 6 | 71.9 | 4.5 | 0.985 | 1.55 | 27.2 | 59.8 |
| Example 7 | 84.8 | 2.7 | 0.992 | 1.82 | 63.2 | 52.0 |
| Example 8 | 76.2 | 4.2 | 0.989 | 1.65 | 56.1 | 58.7 |
| Example 9 | 80.9 | 4.1 | 0.987 | 1.49 | 53.4 | 42.7 |
| Example 10 | 81.8 | 4.6 | 0.982 | 1.14 | 31.4 | 49.5 |

[Table 4]

|  | Composition at inflection point $x_1$ (atom%) | | | | | | | | Ratio A/M at inflection point $x_1$ | Evaluation | |
|---|---|---|---|---|---|---|---|---|---|---|---|
|  | Em element content M | | Ea element content A | | Content of other elements | | | M + A | | Reflectance to EUV light (%) | Presence or absence of film peeling defect |
|  | Ru | Rh | Cr | Nb | N | O | Si | | | | |
| Example 1 | 33.4 | 18.2 | 5.7 | 0.0 | 21.1 | 0.0 | 21.6 | 57.3 | 0.110 | 63.4 | Absence |
| Example 2 | 37.3 | 16.6 | 4.6 | 0.0 | 8.1 | 0.0 | 33.4 | 58.5 | 0.085 | 63.5 | Absence |
| Example 3 | 39.8 | 14.8 | 5.2 | 0.0 | 8.4 | 0.0 | 31.8 | 59.8 | 0.095 | 62.9 | Absence |
| Example 4 | 44.7 | 23.5 | 0.0 | 1.7 | 0.0 | 0.0 | 30.1 | 69.9 | 0.025 | 63.2 | Absence |
| Example 5 | 53.2 | 0.0 | 0.0 | 2.1 | 15.3 | 0.0 | 29.4 | 55.3 | 0.039 | 63.7 | Absence |
| Example 6 | 37.1 | 0.0 | 0.0 | 3.1 | 4.0 | 12.0 | 43.8 | 40.2 | 0.084 | 63.5 | Absence |
| Example 7 | 34.3 | 13.7 | 0.0 | 0.0 | 16.3 | 0.0 | 35.7 | 48.0 | 0.000 | 63.6 | Presence |
| Example 8 | 29.1 | 11.5 | 0.7 | 0.0 | 26.6 | 0.0 | 32.1 | 41.3 | 0.017 | 63.8 | Presence |
| Example 9 | 34.1 | 22.8 | 0.0 | 0.4 | 17.2 | 0.0 | 25.5 | 57.3 | 0.007 | 64.2 | Presence |
| Example 10 | 50.0 | 0.0 | 0.0 | 0.5 | 7.0 | 12.2 | 30.3 | 50.5 | 0.010 | 63.6 | Presence |

Reference Signs List

| | |
|---|---|
| 1 | Substrate |
| 2 | Multilayer reflective film |
| 3 | Protective film |
| 4 | Absorber film |
| 4a | Absorber pattern |
| 5 | Back conductive film |
| 6 | Etching mask film |
| 11 | Resist film |
| 11a | Resist pattern |
| 32 | First layer |
| 34 | Second layer |
| 50 | EUV exposure apparatus |
| 51 | EUV light generation unit |
| 52 | Laser light source |
| 53 | Tin droplet generation unit |
| 54 | Catching unit |
| 55 | Collector |
| 56 | Irradiation optical system |
| 57 | Projection optical system |
| 58 | Reticle stage |
| 59 | Wafer stage |
| 60 | Semiconductor substrate |
| 90 | Substrate with a multilayer reflective film |
| 100 | Reflective mask blank |
| 200 | Reflective mask |

**Claims**

1. A substrate with a multilayer reflective film (90) comprising: a substrate (1); a multilayer reflective film (2) provided on the substrate (1); and a protective film (3) provided on the multilayer reflective film (2), wherein

   the protective film (3) includes a first layer (32) and a second layer (34), and the first layer (32) is disposed between the second layer (34) and the multilayer reflective film (2),
   the protective film (3) includes at least one metal element Em and at least one additive element Ea, and a content of the metal element Em in the second layer (34) is larger than a content of the metal element Em in the first layer (32),
   the metal element Em is an element having a Fermi level of -4.7 eV or less,
   the additive element Ea is an element having a Fermi level of more than -4.7 eV, and
   in a content distribution of a component included in the protective film (3) with respect to a position x in a film thickness direction of the protective film (3), when a position x at which a component dominance of the second layer (34) is switched to a component dominance of the first layer (32) is an inflection point $x_1$, a content of the metal element Em is M, and a content of the additive element Ea is A, a ratio A/M at the inflection point $x_1$ is 0.020 or more.

2. The substrate with a multilayer reflective film (90) according to claim 1, wherein the metal element Em is one or more elements selected from ruthenium (Ru), rhodium (Rh), and iridium (Ir).

3. The substrate with a multilayer reflective film (90) according to claim 1 or 2, wherein the additive element Ea is one or more elements selected from Tl, Hf, Ti, Zr, Y, Mn, In, Ga, Cd, Bi, Ta, Pb, Ag, Al, V, Nb, Sn, Zn, Hg, Cr, Fe, Sb, W, Mo, and Cu.

4. The substrate with a multilayer reflective film (90) according to claim 1 or 2, wherein the content A of the additive element Ea at the inflection point $x_1$ is 1 atom% or more and 15 atom% or less.

5. The substrate with a multilayer reflective film (90) according to claim 1 or 2, wherein the content M of the metal element Em at the inflection point $x_1$ is 5 atom% or more and 80 atom% or less.

6. The substrate with a multilayer reflective film (90) according to claim 1 or 2, wherein the ratio A/M at the inflection point $x_1$ is less than 0.17.

7. The substrate with a multilayer reflective film (90) according to claim 1 or 2, wherein the first layer (32) includes silicon (Si) and at least one selected from nitrogen (N) and oxygen (O), and a total content of nitrogen (N) and oxygen (O) at the inflection point $x_1$ is 2 atom% or more.

8. The substrate with a multilayer reflective film (90) according to claim 7, wherein the total content of nitrogen (N) and oxygen (O) at the inflection point $x_1$ is 35 atom% or less.

9. A reflective mask blank (100) comprising: a substrate (1); a multilayer reflective film (2) provided on the substrate (1); a protective film (3) provided on the multilayer reflective film (2); and an absorber film (4) provided on the protective film (3), wherein

the protective film (3) includes a first layer (32) and a second layer (34), and the first layer (32) is disposed between the second layer (34) and the multilayer reflective film (2),
the protective film includes at least one metal element Em and at least one additive element Ea, and a content of the metal element Em in the second layer (34) is larger than a content of the metal element Em in the first layer (32),
the metal element Em is an element having a Fermi level of -4.7 eV or less,
the additive element Ea is an element having a Fermi level of more than -4.7 eV, and
in a content distribution of a component contained in the protective film (3) with respect to a position x in a film thickness direction of the protective film (3), when a position x at which a component dominance of the second layer (34) is switched to a component dominance of the first layer (32) is an inflection point $x_1$, a content of the metal element Em is M, and a content of the additive element Ea is A, a ratio A/M at the inflection point $x_1$ is 0.020 or more.

10. The reflective mask blank (100) according to claim 9, wherein the metal element Em is one or more elements selected from ruthenium (Ru), rhodium (Rh), and iridium (Ir).

11. The reflective mask blank (100) according to claim 9 or 10, wherein the additive element Ea is one or more elements selected from Tl, Hf, Ti, Zr, Y, Mn, In, Ga, Cd, Bi, Ta, Pb, Ag, Al, V, Nb, Sn, Zn, Hg, Cr, Fe, Sb, W, Mo, and Cu.

12. The reflective mask blank (100) according to claim 9 or 10, wherein the content A of the additive element Ea at the inflection point $x_1$ is 1 atom% or more and 15 atom% or less.

13. The reflective mask blank (100) according to claim 9 or 10, wherein the content M of the metal element Em at the inflection point $x_1$ is 5 atom% or more and 80 atom% or less.

14. The reflective mask blank (100) according to claim 9 or 10, wherein the ratio A/M at the inflection point $x_1$ is less than 0.17.

15. The reflective mask blank (100) according to claim 9 or 10, wherein the first layer (32) includes silicon (Si) and at least one selected from nitrogen (N) and oxygen (O), and a total content of nitrogen (N) and oxygen (O) at the inflection point $x_1$ is 2 atom% or more.

16. The reflective mask blank (100) according to claim 15, wherein the total content of nitrogen (N) and oxygen (O) at the inflection point $x_1$ is 35 atom% or less.

17. A reflective mask (200) comprising: a substrate (1); a multilayer reflective film (2) provided on the substrate (1); a protective film (3) provided on the multilayer reflective film (2); and an absorber pattern (4a) provided on the protective film (3), wherein

the protective film (3) includes a first layer (32) and a second layer (34), and the first layer (32) is disposed between the second layer (34) and the multilayer reflective film (2),

the protective film includes at least one metal element Em and at least one additive element Ea, and a content of the metal element Em in the second layer (34) is larger than a content of the metal element Em in the first layer (32),
the metal element Em is an element having a Fermi level of -4.7 eV or less,
the additive element Ea is an element having a Fermi level of more than -4.7 eV, and
in a content distribution of a component contained in the protective film (3) with respect to a position x in a film thickness direction of the protective film (3), when a position x at which a component dominance of the second layer (34) is switched to a component dominance of the first layer (32) is an inflection point $x_1$, a content of the metal element Em is M, and a content of the additive element Ea is A, a ratio A/M at the inflection point $x_1$ is 0.020 or more.

18. The reflective mask (200) according to claim 17, wherein the metal element Em is one or more elements selected from ruthenium (Ru), rhodium (Rh), and iridium (Ir).

19. The reflective mask (200) according to claim 17 or 18, wherein the additive element Ea is one or more elements selected from Tl, Hf, Ti, Zr, Y, Mn, In, Ga, Cd, Bi, Ta, Pb, Ag, Al, V, Nb, Sn, Zn, Hg, Cr, Fe, Sb, W, Mo, and Cu.

20. The reflective mask (200) according to claim 17 or 18, wherein the content A of the additive element Ea at the inflection point $x_1$ is 1 atom% or more and 15 atom% or less.

21. The reflective mask (200) according to claim 17 or 18, wherein the content M of the metal element Em at the inflection point $x_1$ is 5 atom% or more and 80 atom% or less.

22. The reflective mask (200) according to claim 17 or 18, wherein the ratio A/M at the inflection point $x_1$ is less than 0.17.

23. The reflective mask (200) according to claim 17 or 18, wherein the first layer (32) includes silicon (Si) and at least one selected from nitrogen (N) and oxygen (O), and a total content of nitrogen (N) and oxygen (O) at the inflection point $x_1$ is 2 atom% or more.

24. The reflective mask (200) according to claim 23, wherein the total content of nitrogen (N) and oxygen (O) at the inflection point $x_1$ is 35 atom% or less.

25. A method for manufacturing a semiconductor device, comprising a step of performing a lithography process using an exposure apparatus (50) using the reflective mask (200) according to claim 17 or 18 to form a transfer pattern on a transfer object.

**FIG. 1**

**FIG. 2**

**FIG. 3**

**FIG. 4**

100

(a)

11
4
3
2
1
5

(b)

11a
4
3
2
1
5

(c)

11a
4a
3
2
1
5

200

(d)

4a
3
2
1
5

**FIG. 5**

**FIG. 6**

$Y = -0.0233X + 0.14$ (FORMULA 2-1)    $Y = 0.0096X - 0.144$ (FORMULA 2-2)

**FIG. 7**

<div align="center">

**INTERNATIONAL SEARCH REPORT**

</div>

| International application No. |
|---|
| **PCT/JP2023/023882** |

| | |
|---|---|
| **A. CLASSIFICATION OF SUBJECT MATTER** | |
| *G03F 1/24*(2012.01)i; *G03F 1/48*(2012.01)i; *C23C 14/06*(2006.01)i<br>FI: G03F1/24; G03F1/48; C23C14/06 N | |
| According to International Patent Classification (IPC) or to both national classification and IPC | |

| |
|---|
| **B. FIELDS SEARCHED** |
| Minimum documentation searched (classification system followed by classification symbols)<br>G03F1/24; G03F1/48; C23C14/06 |
| Documentation searched other than minimum documentation to the extent that such documents are included in the fields searched<br>Published examined utility model applications of Japan 1922-1996<br>Published unexamined utility model applications of Japan 1971-2023<br>Registered utility model specifications of Japan 1996-2023<br>Published registered utility model applications of Japan 1994-2023 |
| Electronic data base consulted during the international search (name of data base and, where practicable, search terms used) |

| |
|---|
| **C. DOCUMENTS CONSIDERED TO BE RELEVANT** |

| Category* | Citation of document, with indication, where appropriate, of the relevant passages | Relevant to claim No. |
|---|---|---|
| X | JP 2021-128247 A (HOYA CORP.) 02 September 2021 (2021-09-02)<br>paragraphs [0126]-[0129] | 1-25 |
| Y | | 2-3, 10-11, 18-19 |
| Y | WO 2021/200325 A1 (HOYA CORP.) 07 October 2021 (2021-10-07)<br>paragraphs [0051], [0054]-[0060], fig. 2 | 2-3, 10-11, 18-19 |
| Y | WO 2021/132111 A1 (AGC INC.) 01 July 2021 (2021-07-01)<br>claim 11, paragraph [0033] | 2-3, 10-11, 18-19 |
| Y | JP 2021-157097 A (HOYA CORP.) 07 October 2021 (2021-10-07)<br>paragraph [0071] | 3, 11, 19 |

☐ Further documents are listed in the continuation of Box C.    ☑ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **21 July 2023** | **08 August 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

INTERNATIONAL SEARCH REPORT
Information on patent family members

International application No.

**PCT/JP2023/023882**

| Patent document cited in search report | | | Publication date (day/month/year) | Patent family member(s) | Publication date (day/month/year) |
|---|---|---|---|---|---|
| JP | 2021-128247 | A | 02 September 2021 | (Family: none) | |
| WO | 2021/200325 | A1 | 07 October 2021 | KR 10-2022-0161261 A paragraphs [0066], [0069]-[0075], fig. 2 | |
| WO | 2021/132111 | A1 | 01 July 2021 | US 2022/0299862 A1 claim 11, paragraphs [0053]-[0054] KR 10-2022-0122614 A | |
| JP | 2021-157097 | A | 07 October 2021 | US 2023/0072220 A1 paragraph [0090] KR 10-2022-0161258 A | |

Form PCT/ISA/210 (patent family annex) (January 2015)

34

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005268750 A